# EUROPEAN PATENT SPECIFICATION

(11) **EP 4 694 609 B1**
(45) Date of publication and mention of the grant of the patent: **18.11.2026**
(21) Application number: 25183560.9
(22) Date of filing: 18.06.2025
(51) Int. Cl.: H10B 12/00, H10W 10/20, H10W 10/00

(54) **SEMICONDUCTOR DEVICE INCLUDING AIR GAP BETWEEN ACTIVE PATTERNS**
HALBLEITERBAUELEMENT MIT LUFTSPALT ZWISCHEN AKTIVEN MUSTERN
DISPOSITIF SEMI-CONDUCTEUR COMPRENANT UN ENTREFER ENTRE DES MOTIFS ACTIFS

(30) Priority: 06.08.2024 KR 20240104880
(43) Date of publication of application: 11.02.2026
(73) Proprietor: Samsung Electronics Co., Ltd., Suwon-si, Gyeonggi-do 16677 (KR)
(72) Inventor: KO, Byengha, Suwon-si, Gyeonggi-do 16677 (KR); MUN, Geumbi, Suwon-si, Gyeonggi-do 16677 (KR); LEE, Yoonji, Suwon-si, Gyeonggi-do 16677 (KR); JEONG, Hyejeong, Suwon-si, Gyeonggi-do 16677 (KR); KIM, Iksoo, Suwon-si, Gyeonggi-do 16677 (KR); HWANG, Kwangtae, Suwon-si, Gyeonggi-do 16677 (KR)
(74) Representative: Kuhnen & Wacker Patent- und Rechtsanwaltsbüro PartG mbB

(56) References cited:
- US-A1- 2023 363 143
- US-A1- 20240 023 311

## Description

### TECHNICAL FIELD

The present disclosure relates to a semiconductor device including an air gap between active patterns, and a method for forming the same.

### BACKGROUND

Research is being conducted to reduce sizes of elements constituting a semiconductor device and to improve performance thereof. For example, in the DRAM, research is being conducted to reliably and stably form elements having reduced sizes, but as the sizes of the elements are reduced, dispersion characteristics of the semiconductor device are deteriorating.

US 2024/023311 discloses a semiconductor memory device according to the preamble of claim 1.

### SUMMARY

An aspect of the present disclosure is to provide a semiconductor device capable of increasing a degree of integration and improving performance.

An aspect of the present disclosure is to provide a method for forming the semiconductor device.

A semiconductor device according to the claimed invention is provided. The semiconductor device includes active patterns spaced apart from each other in a first direction and a second direction that are perpendicular to each other, the active patterns including a first-first active pattern, a second-first active pattern, and a third-first active pattern, the second-first active pattern between the first-first active pattern and the third-first active pattern, a back gate electrode extending between the first-first active pattern and the second-first active pattern and extending in the first direction, a first word line and a second word line extending between the second-first active pattern and the third-first active pattern and spaced apart from each other in the second direction, an insulating pattern between the first word line and the second word line, a first air gap between the first-first active pattern and the second-first active pattern, where the back gate electrode is on the first air gap, and a second air gap between the second-first active pattern and the third-first active pattern, where the first word line, the second word line, and the insulating pattern are on the second air gap.

A semiconductor device according to an aspect of the present disclosure, not part of the claimed invention, is provided. The semiconductor device includes active patterns spaced apart from each other in a first direction and a second direction that are perpendicular to each other, the active patterns including a first-first active pattern, a second-first active pattern, and a third-first active pattern, the second-first active pattern between the first-first active pattern and the third-first active pattern, a first bit line structure extending in the second direction and electrically connected to a lower surface of the first-first active pattern, a lower surface of the second-first active pattern, and a lower surface of the third-first active pattern, a back gate electrode extending between the first-first active pattern and the second-first active pattern and extending in the first direction, a first word line and a second word line extending between the second-first active pattern and the third-first active pattern and spaced apart from each other in the second direction, an insulating pattern between the first word line and the second word line, and a first air gap between the first bit line structure and the back gate electrode and between the first-first active pattern and the second-first active pattern.

A semiconductor device according to an aspect of the present disclosure, not part of the claimed invention, is provided. The semiconductor device includes active patterns spaced apart from each other in a first direction and a second direction that are perpendicular to each other, the active patterns including a first-first active pattern, a second-first active pattern, and a third-first active pattern, the second-first active pattern between the first-first active pattern and the third-first active pattern, a first bit line structure extending in the second direction and electrically connected to a lower surface of the first-first active pattern, a lower surface of the second-first active pattern, and a lower surface of the third-first active pattern, a back gate electrode extending between the first-first active pattern and the second-first active pattern and extending in the first direction, a first word line and a second word line extending between the second-first active pattern and the third-first active pattern and spaced apart from each other in the second direction, an insulating pattern between the first word line and the second word line, and an air gap between the second-first active pattern and the third-first active pattern, where the first word line, the second word line, and the insulating pattern are on the air gap.

### BRIEF DESCRIPTION OF DRAWINGS

The above and other aspects, features, and advantages of the present disclosure will be more clearly understood from the following detailed description, taken in conjunction with the accompanying drawings, in which:
FIGS. 1 to 3 are views illustrating a semiconductor device according to some embodiments of the present disclosure.
FIG. 4 is a schematic perspective view illustrating an example of a semiconductor device according to some embodiments of the present disclosure.
FIGS. 5A, 5B, 5C, 6A, 6B, and 6C are views illustrating examples of semiconductor devices according to some embodiments of the present disclosure.
FIGS. 7A and 7B are cross-sectional views illustrating examples of semiconductor devices according to some embodiments of the present disclosure.
FIGS. 8A and 8B are cross-sectional views illustrating examples of semiconductor devices according to some embodiments of the present disclosure.
FIG. 9 is a cross-sectional view illustrating an example of semiconductor devices according to some embodiments of the present disclosure.
FIG. 10 is a cross-sectional view illustrating an example of semiconductor devices according to some embodiments of the present disclosure.
FIGS. 11A, 11B, 11C, and 11D are views illustrating examples of semiconductor devices according to some embodiments of the present disclosure.
FIGS. 12A, 12B, and 12C are cross-sectional views illustrating examples of semiconductor devices according to some embodiments of the present disclosure.
FIG. 13A, FIG. 13B, FIG. 14, FIG. 15, FIG. 16, FIG. 17A, FIG. 17B, FIG. 17C, FIG. 18A, and FIG. 18B are cross-sectional views illustrating examples of a method for forming a semiconductor device according to some embodiments of the present disclosure.

### DETAILED DESCRIPTION

Hereinafter, terms such as "upper," "middle," "lower," or the like may be replaced with other terms, for example, terms such as "first," "second," "third," or the like, and may be used to describe elements of the specification. Terms such as "first," "second," "third," or the like may be used to describe various elements, but the elements are not limited by the terms, and a "first element" may be named a "second element." In the specification, terms such as "lower," "upper," "upper end," "lower end," or the like may be terms described based on the drawings.

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "includes", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. Components or layers described with reference to "overlap" in a particular direction may be at least partially obstructed by one another when viewed along a line extending in the particular direction or in a plane perpendicular to the particular direction.

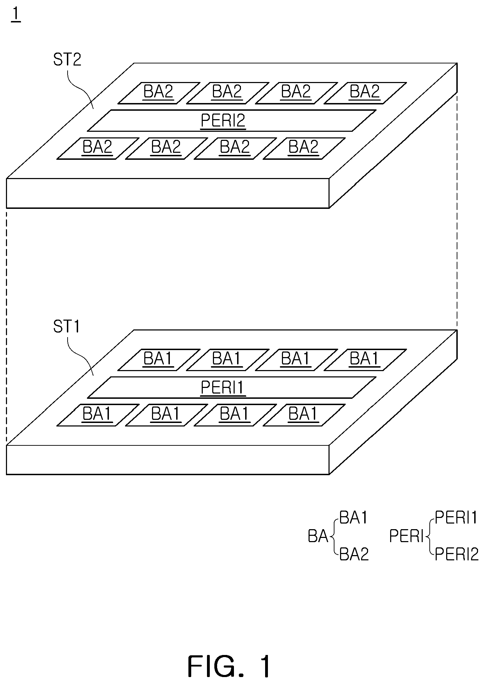

Referring to FIGS. 1, 2, and 3, a semiconductor device 1 according to an embodiment may include a first structure ST1 and a second structure ST2 vertically overlapping the first structure ST1. The second structure ST2 may be disposed on the first structure ST1. According to an embodiment, the second structure ST2 may be disposed below the first structure ST1.

In an embodiment, the first structure ST1 may be a first chip structure including a memory region CR and a first peripheral region, and the second structure ST2 may be a second chip structure including a peripheral circuit. The first structure ST1 and the second structure ST2 may be formed by being bonded by a bonding process such as a wafer bonding process. Therefore, the first structure ST1 may be in contact with and bonded to the second structure ST2.

The semiconductor device 1 may include a plurality of banks BA and an outer peripheral region PERI.

The outer peripheral region PERI may include a first peripheral region PERI1 in the first structure ST1 and a second peripheral region PERI2 in the second structure ST2. The outer peripheral region PERI may be a peripheral region in which peripheral circuits for input/output of data or commands, or input of power/ground are disposed.

The plurality of banks BA may include a first bank region BA1 in the first structure ST1 and a second bank region BA2 in the second structure ST2.

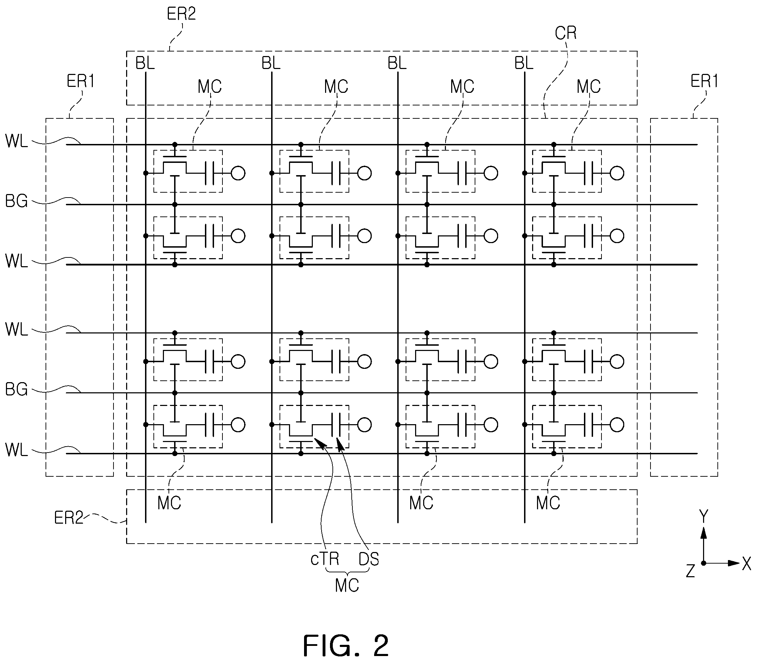

The first bank region BA1 in the first structure ST1 may include the memory region CR (see FIG. 2). The memory region CR may include memory cells MC arranged in a first horizontal direction (X) and a second horizontal direction (Y) that are perpendicular to each other, word lines WL connected to the memory cells MC and extending in the first horizontal direction (X), and bit lines BL connected to the memory cells MC and extending in the second horizontal direction (Y). The first horizontal direction (X) and the second horizontal direction (Y) may be perpendicular to each other.

The word lines WL may cross the memory region CR in the first horizontal direction (X). The bit lines BL may cross the memory region CR in the second horizontal direction (Y). Each of the memory cells MC may include a data storage structure DS that may serve to store information, and a cell transistor cTR electrically connected to the data storage structure DS. In a memory such as a DRAM or the like, the information storage structure DS may be a cell capacitor capable of storing information. The memory region CR may further include back gate lines BG. Each of the back gate lines BG may be disposed between a pair of word lines WL adjacent to each other in the second horizontal direction (Y), among the word lines WL. Each of the back gate lines BG may be disposed between vertical channel regions of cell transistors cTR.

The second bank region BA2 in the second structure ST2 may include a peripheral circuit such as a sense amplifier electrically connected to the bit lines BL in the memory region CR, a sub-word line driver electrically connected to the word lines WL in the memory region CR, a back gate control circuit electrically connected to the back gate lines BG in the memory region, or the like.

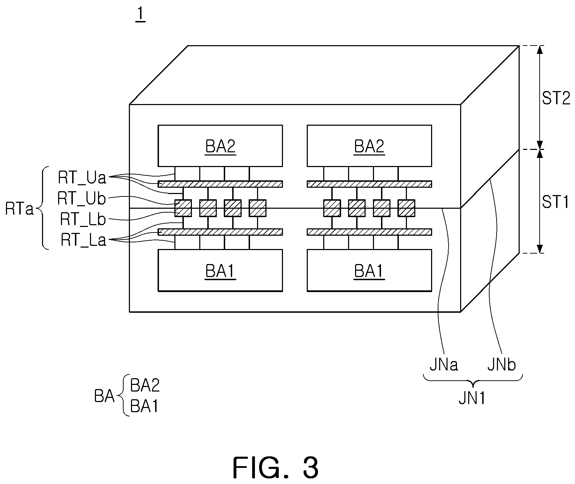

The first and second structures ST1 and ST2 may further include a routing interconnection structure RTa (see FIG. 3) electrically connecting the first bank region BA1 and the second bank region BA2. For example, the routing interconnection structure RTa may include a first routing interconnection structure (RT_La and RT_Lb) disposed in the first structure ST1 and a second routing interconnection structure (RT_Ua and RT_Ub) disposed in the second structure ST2.

The first routing interconnection structure (RT_La and RT_Lb) may include a first interconnection structure RT_La electrically connected to the first bank region BA1, and first bonding pads RT_Lb electrically connected to the first interconnection structure RT_La. The second routing interconnection structure (RT_Ua and RT_Ub) may include a second interconnection structure RT_Ua electrically connected to the second bank region BA2 and second bonding pads RT_Ub electrically connected to the second interconnection structure RT_Ua.

The first bonding pads RT_Lb and the second bonding pads RT_Ub may be in contact with and bonded to each other. For example, the first bonding pads RT_Lb and the second bonding pads RT_Ub may include copper, and may be bonded to each other by a metal-to-metal bonding process. Therefore, a bonding surface JN1 between the first structure ST1 and the second structure ST2 may include intermetallic bonding regions JNa in which the first bonding pads RT_Lb of the first structure ST1 and the second bonding pads RT_Ub of the second structure ST2 are bonded to each other, and inter-dielectric bonding regions JNb in which a dielectric of the first structure ST1 and a dielectric of the second structure ST2 are bonded to each other.

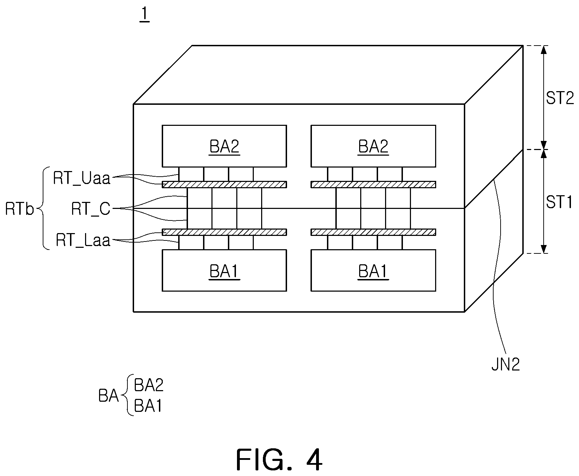

Next, an example of the routing interconnection structure RTa and an example of the bonding surface JN1, described above, will be described with reference to FIG. 4. FIG. 4 may be a schematic perspective view illustrating an example of the routing interconnection structure RTa and an example of the bonding surface JN1, described in FIG. 3.

In an example, referring to FIG. 4, the routing interconnection structure RTa described in FIG. 3 may be replaced with a routing interconnection structure RTb in which the first bonding pads RT_Lb and the second bonding pads RT_Ub are omitted, and the bonding surface JN1 described in FIG. 3 may be replaced with a bonding surface JN2 in which the intermetallic bonding regions JNa is omitted.

The routing interconnection structure RTb may include a first interconnection structure RT_Laa included in the first structure ST1 and electrically connected to the first bank region BA1, a second interconnection structure RT_Uaa included in the second structure ST2 and electrically connected to the second bank region BA2, and a connection structure RT_C extending from the first structure ST1 to the second structure ST2 and electrically connecting the first and second interconnection structures RT_Laa and RT_Uaa.

The bonding surface JN2 between the first structure ST1 and the second structure ST2 may be formed as a dielectric bonding surface in which a dielectric of the first structure ST1 and a dielectric of the second structure ST2 are bonded to each other. The connection structure RT_C may include a through-via or a through-connection plug that may penetrate or extend into the bonding surface JN2.

Hereinafter, examples of the memory region CR of the first bank region BA1 of the first structure ST1 of the semiconductor element 1 will be described with reference to FIGS. 1 to 3. Hereinafter, examples of the memory region CR described in FIGS. 1 to 3 will be described, but in the example embodiments described below, the routing interconnection structure RTa and the bonding surface JN1, described in FIG. 3, may be replaced with the routing interconnection structure RTb and the bonding surface JN2, described in FIG. 4. In addition, the example embodiments described below may be combined with each other to form an example embodiment.

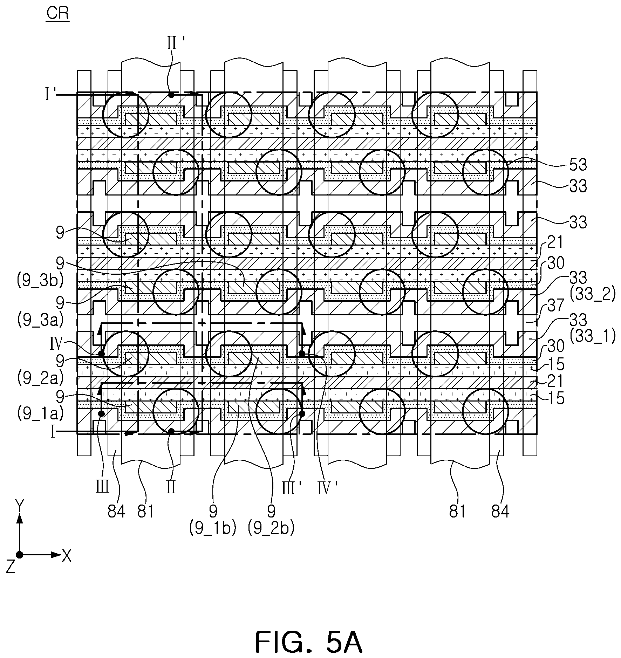

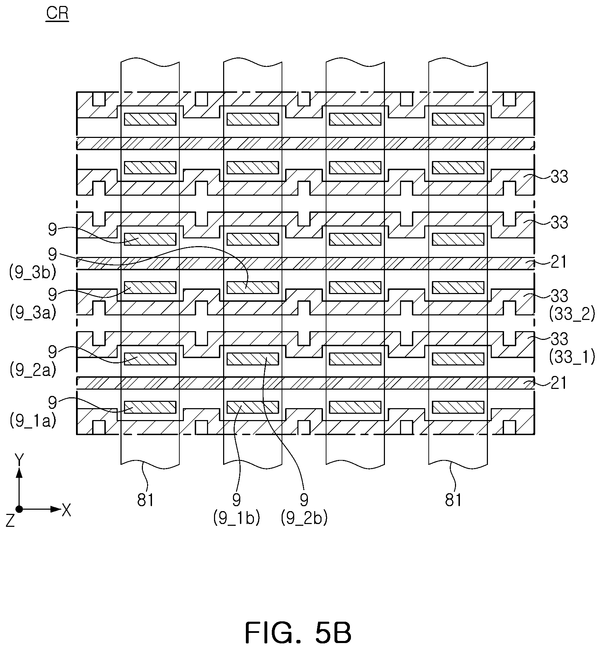

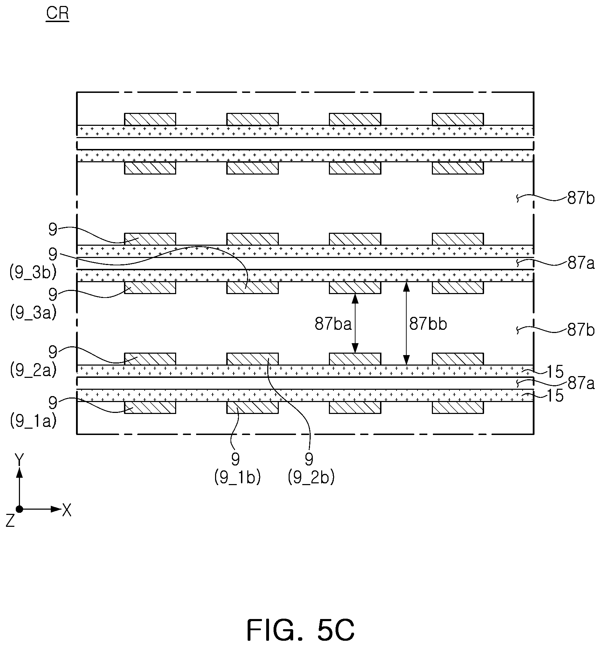

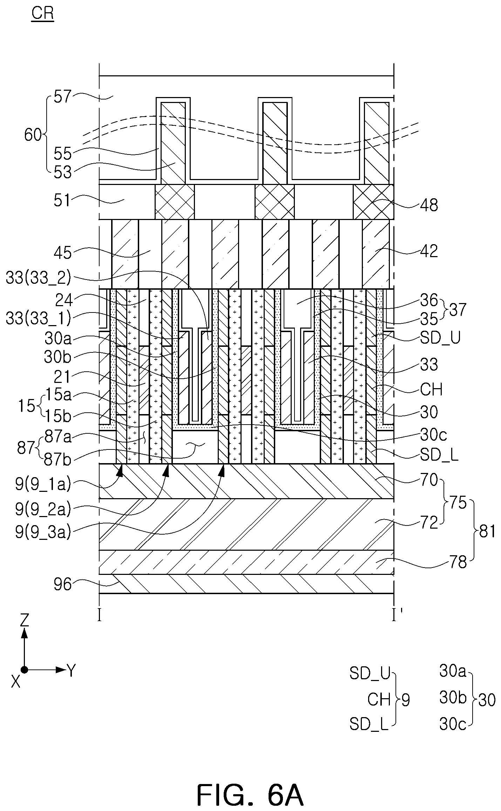

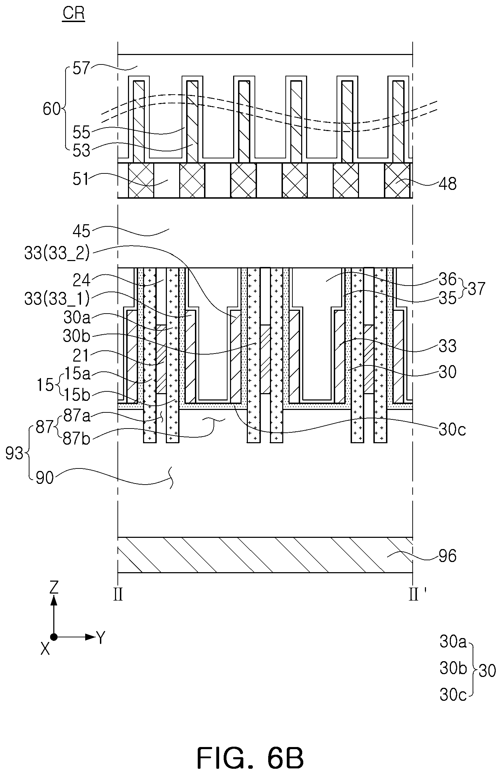

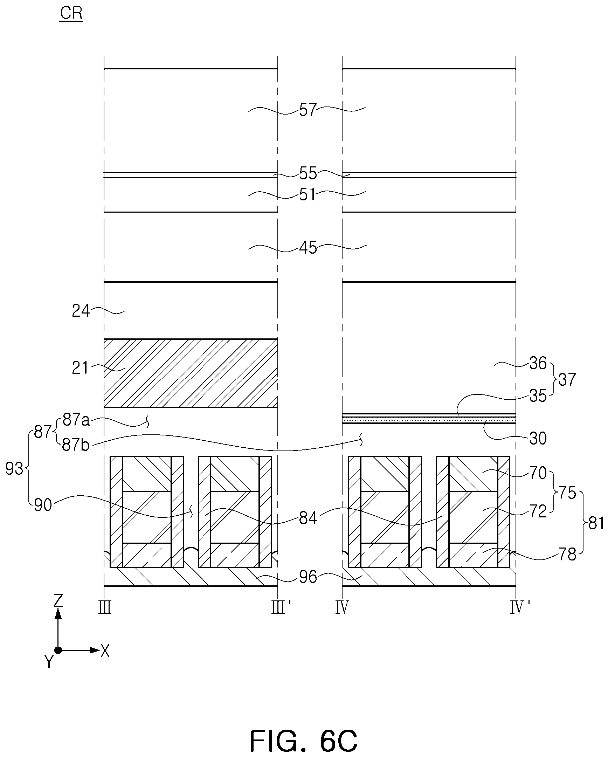

Referring to FIGS. 5A, 5B, 5C, 6A, 6B, and 6C, examples of the memory region CR of the semiconductor element 1 will be described. In FIGS. 5A to 6C, FIG. 5A is a plan view illustrating the memory region CR of the semiconductor device 1, FIG. 5B is a plan view illustrating some elements of FIG. 5A, FIG. 5C is a plan view illustrating some elements of FIG. 5A and air gaps 87a and 87b, FIG. 6A is a cross-sectional view illustrating a region taken along line I-I' of FIG. 5A, FIG. 6B is a cross-sectional view illustrating a region taken along line II-II' of FIG. 5A, and FIG. 6C is a cross-sectional view illustrating a region taken along lines III-III' and IV-IV' of FIG. 5A.

Referring to FIGS. 5A to 6C along with FIGS. 1 to 3, the memory region CR of the semiconductor device 1 may include active patterns 9, word lines 33, back gate electrodes 21, and a lower capping insulating layer 96.

Each of the active patterns 9 may include a semiconductor material that may be used as a channel region of a transistor. For example, each of the active patterns 9 may include at least one of a silicon layer, a germanium layer, a silicon-germanium layer, an oxide semiconductor layer, or a two-dimensional material layer having semiconductor properties. For example, each of the active patterns 9 may include a single-crystal silicon layer. The active patterns 9 may be disposed in the first horizontal direction (X) (which may be an example for the first direction in the claims) and the second horizontal direction (Y) (which may be an example for the second direction in the claims). Each of the active patterns 9 may have a bar shape extending in the first horizontal direction (X). Each of the active patterns 9 (see FIG. 6A) may include a first source/drain region SD_L, a second source/drain region SD_U disposed at a higher level than the first source/drain region SD_L (e.g., a distance in the Z direction between the second source/drain region SD_U and an upper surface of the lower capping insulating layer 96 is greater than a distance in the Z direction between the first source/drain region SD_L and the upper surface of the lower capping insulating layer 96), and a channel region CH between the first and second source/drain regions SD_L and SD_U. The channel region CH may be a vertical channel region.

The active patterns 9 (see FIGS. 5A to 5C) may include a first-first active pattern 9_1a, a second-first active pattern 9_2a, and a third-first active pattern 9_3a, arranged sequentially in the second horizontal direction (Y), and a first-second active pattern 9_1b, a second-second active pattern 9_2b, and a third-second active pattern 9_3b, arranged sequentially in the second horizontal direction (Y). The first-first active pattern 9_1a and the first-second active pattern 9_1b may be arranged sequentially in the first horizontal direction (X), the second-first active pattern 9_2a and the second-second active pattern 9_2b may be arranged sequentially in the first horizontal direction (X), and the third-first active pattern 9_3a and the third-second active pattern 9_3b may be arranged sequentially in the first horizontal direction (X).

Each of the back gate electrodes 21 may have a linear shape extending in the first horizontal direction (X) (see FIGS. 5A and 5B). The back gate electrodes 21 may be the back gate lines (BG of FIG. 2) described above. The word lines 33 may be the word lines (WL of FIG. 2) described above. The word lines 33 may be spaced apart from each other in the second horizontal direction (Y). Between a pair of back gate electrodes 21 adjacent in the second horizontal direction (Y), a pair of active patterns 9 adjacent in the second horizontal direction (Y) may be disposed, and between a pair of active patterns 9 adjacent in the second horizontal direction (Y), a pair of word lines 33 adjacent to each other in the second horizontal direction (Y) may be disposed. The word lines 33 may be disposed between the channel regions CH of the active patterns 9. The word lines 33 may also be referred to as cell gate electrodes. Each of the word lines 33 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi and/or a combination thereof, but is not limited thereto. Each of the word lines 33 may include a single layer or multiple layers of the conductive materials described above.

A back gate electrode 21 may pass or extend between the first-first active pattern 9_1a and the second-first active pattern 9_2a, and a pair of word lines 33_1 and 33_2 adjacent to each other may pass or extend between the second-first active pattern 9_2a and the third-first active pattern 9_3a.

The pair of word lines 33_1 and 33_2 may include a first word line 33_1 adjacent to the second-first active pattern 9_2a, and a second word line 33_2 adjacent to the third-first active pattern 9_3a.

The memory region CR of the semiconductor device 1 may further include an insulating pattern 37 (see FIGS. 6A to 6C) between the word lines 33, adjacent to each other, and back gate capping patterns 24 on the back gate electrodes 21.

The insulating pattern 37 may be disposed between the word lines 33, adjacent to each other, and may extend to cover upper portions of the word lines 33. The insulating pattern 37 may have an upper surface coplanar with upper surfaces of the active patterns 9. The insulating pattern 37 may include a first material layer 36 and a second material layer 35 covering or overlapping side and lower surfaces of the first material layer 36.

The back gate capping patterns 24 may be disposed on upper surfaces of the back gate electrodes 21. The back gate capping patterns 24 may have upper surfaces coplanar with the upper surfaces of the active patterns 9. The back gate capping patterns 24 may be formed of an insulating material.

The memory region CR of the semiconductor device 1 may further include a cell gate dielectric layer 30 and a back gate dielectric layer 15.

The cell gate dielectric layer 30 may include a portion disposed between the word lines 33 and the active patterns 9. For example, the cell gate dielectric layer 30 may include a first cell gate dielectric portion 30a contacting the second-first active pattern 9_2a, a second cell gate dielectric portion 30b contacting the third-first active pattern 9_3a, and a third cell gate dielectric portion 30c extending from lower regions of the first and second cell gate dielectric portions 30a and 30b below lower surfaces of the first and second word lines 33_1 and 33_2. The third cell gate dielectric portion 30c may extend below the lower surface of the insulating pattern 37. The first cell gate dielectric portion 30a may be disposed between the second-first active pattern 9_2a and the first word line 33_1, and between the second-first active pattern 9_2a and the insulating pattern 37. The second cell gate dielectric portion 30b may be disposed between the third-first active pattern 9_3a and the second word line 33_2, and between the third-first active pattern 9_3a and the insulating pattern 37. An upper surface of the cell gate dielectric layer 30 may be coplanar with the upper surfaces of the active patterns 9, and a lower surface of the cell gate dielectric layer 30 may be disposed at a higher level than the lower surfaces of the active patterns 9 (e.g., a distance in the Z direction between the lower surface of the cell gate dielectric layer 30 and an upper surface of the lower capping insulating layer 96 is greater than a distance in the Z direction between the lower surfaces of the active patterns 9 and the upper surface of the lower capping insulating layer 96).

The back gate dielectric layer 15 may include a portion disposed between the back gate electrode 21 and the active patterns 9. For example, the back gate dielectric layer 15 may include a first back gate dielectric portion 15a contacting the first-first active pattern 9_1a and a second back gate dielectric portion 15b contacting the second-first active pattern 9_2a. In the back gate dielectric layer 15, the first back gate dielectric portion 15a and the second back gate dielectric portion 15b may be spaced apart from each other. The first back gate dielectric portion 15a may be disposed between the first-first active pattern 9_1a and the back gate electrode 21, and between the first-first active pattern 9_1a and the back gate capping pattern 24, and the second back gate dielectric portion 15b may be disposed between the second-first active pattern 9_2a and the back gate electrode 21, and between the second-first active pattern 9_2a and the back gate capping pattern 24. An upper surface of the back gate dielectric layer 15 may be coplanar with the upper surfaces of the active patterns 9, and a lower surface of the back gate dielectric layer 15 may be coplanar with the lower surfaces of the active patterns 9. The upper surface of the back gate dielectric layer 15 may be disposed on substantially the same level as (e.g., coplanar with) the upper surface of the cell gate dielectric layer 30, and the lower surface of the back gate dielectric layer 15 may be disposed at a lower level than the lower surface of the cell gate dielectric layer 30 (e.g., a distance in the Z direction between the lower surface of the back gate dielectric layer 15 and an upper surface of the lower capping insulating layer 96 is less than a distance in the Z direction between the lower surface of the cell gate dielectric layer 30 and the upper surface of the lower capping insulating layer 96).

In an example, a vertical length of each of the word lines 33 may be greater than a vertical length of each of the back gate electrodes 21.

In the specification, the "vertical length" may be defined as a distance between an upper surface and a lower surface in a given direction. For example, the vertical length of the word line 33 may be a length between a lower surface of the word line 33 and an upper surface of the word line 33 in the Z direction.

Upper surfaces of the word lines 33 may be disposed at a higher level than upper surfaces of the back gate electrodes 21 (e.g., a distance in the Z direction between the upper surfaces of the word lines 33 and an upper surface of the lower capping insulating layer 96 is greater than a distance in the Z direction between the upper surfaces of the back gate electrodes 21 and the upper surface of the lower capping insulating layer 96). Lower surfaces of the word lines 33 may be disposed at a lower level than lower surfaces of the back gate electrodes 21 (e.g., a distance in the Z direction between the lower surfaces of the word lines 33 and an upper surface of the lower capping insulating layer 96 is less than a distance in the Z direction between the lower surfaces of the back gate electrodes 21 and the upper surface of the lower capping insulating layer 96).

The memory region CR of the semiconductor device 1 may further include bit line structures 81, bit line spacers 84, and the lower capping insulating layer 96.

Each of the bit line structures 81 may have a linear shape extending in the second horizontal direction (Y) (see FIGS.5A and 5B) . Each of the bit line structures 81 may include a bit line 75 and a bit line capping pattern 78 below the bit line 75 (see FIGS. 6A and 6C). The bit line 75 may be the bit line (BL of FIG. 2) described above.

The bit line 75 may include doped polysilicon, a metal, a conductive metal nitride, a metal-semiconductor compound, a conductive metal oxide, conductive graphene, a carbon nanotube, or a combination thereof. For example, the bit line 75 may be formed of, but is not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotubes, and/or a combination thereof. The bit line 75 may include a single layer or multiple layers of the above-mentioned conductive materials. For example, the bit line 75 may include a first material layer 70 and a second material layer 72 below the first material layer 70 (see FIGS. 6A and 6C). The first material layer 70 may include a doped semiconductor material layer, and the second material layer 72 may include at least one of a metal, a metal compound, or a metal-semiconductor compound. The first material layer 70 may include a polysilicon layer having an N-type conductivity type, and the second material layer 72 may include at least one of Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, and/or NiSi. The bit line capping pattern 78 may be formed of an insulating material, such as silicon nitride or the like. The bit line 75 and the bit line capping pattern 78 may be aligned vertically.

The bit line spacers 84 may be disposed on side surfaces of the bit line structures 81 (see FIGS. 5A and 6C). The bit line spacers 84 may be in contact with the side surfaces of the bit line structures 81. The bit line spacers 84 may be formed of an insulating material.

The lower capping insulating layer 96 may be disposed below the bit line structures 81 and the bit line spacers 84 (see FIG. 6C), and may be disposed below a space between the bit line structures 81. The lower capping insulating layer 96 may include a portion extending into a space between the bit line spacers 84 adjacent to each other.

The memory region CR of the semiconductor device 1 may further include an air gap structure 93 (see FIGS. 6B and C). The air gap structure 93 may be an empty space having a dielectric constant lower than a dielectric constant of silicon oxide.

The air gap structure 93 may include a first air gap structure 87 and a second air gap structure 90 below the first air gap structure 87.

The first air gap structure 87 may include first air gaps 87a and second air gaps 87b. An upper end of at least one of the first air gaps 87a and an upper end of at least one of the second air gaps 87b may be at different respective levels. The upper end of at least one of the first air gaps 87a may be disposed at a different level from the upper end of at least one of the second air gaps 87b (e.g., the upper ends of the at least one of the first/second air gaps 87a, 87b are not coplanar and/or are free from overlap in the second horizontal direction Y).

The first air gaps 87a may be disposed at a higher level than the bit line structures 81 (e.g., a distance in the Z direction between the first air gaps 87a and an upper surface of the lower capping insulating layer 96 is greater than a distance in the Z direction between the bit line structures 81 and the upper surface of the lower capping insulating layer 96) and at a lower level than the back gate electrodes 21 (e.g., a distance in the Z direction between the first air gaps 87a and an upper surface of the lower capping insulating layer 96 is less than a distance in the Z direction between the back gate electrodes 21 and the upper surface of the lower capping insulating layer 96). The first air gaps 87a may be disposed below the back gate electrodes 21. In each of the first air gaps 87a, an upper portion of the first air gap 87a may be defined by a lower surface of the back gate electrode 21, both sides of the first air gap 87a may be defined by the first and second back gate dielectric portions 15a and 15b (see FIG. 6B), first lower portions of the first air gap 87a vertically overlapping the bit line structures 81 and the bit line spacers 84 may be defined by the bit line structures 81 and the bit line spacers 84, and second lower portions of the first air gap 87a not vertically overlapping the bit line structures 81 and the bit line spacers 84 may be connected to the second air gap structure 90. A lower surface of the back gate electrode 21 may be exposed by the first air gap 87a, the first and second back gate dielectric portions 15a and 15b may be exposed by the first air gap 87a, and upper surfaces of the bit line structures 81 and the bit line spacers 84 vertically overlapping the first air gap 87a may be exposed by the first air gap 87a.

The first air gap 87a may be disposed between a structure including the bit line structures 81 and the bit line spacers 84 and the back gate electrode 21, may be disposed between the first-first active pattern 9_1a and the second-first active pattern 9_2a, and may extend from a portion disposed between the first-first active pattern 9_1a and the second-first active pattern 9_2a to between the first-second active pattern 9_1b and the second-second active pattern 9_2b.

The second air gaps 87b may be disposed at a higher level than the bit line structures 81 (e.g., a distance in the Z direction between the second air gaps 87b and an upper surface of the lower capping insulating layer 96 is greater than a distance in the Z direction between the bit line structures 81 and the upper surface of the lower capping insulating layer 96) and at a lower level than the word lines 33 (e.g., a distance in the Z direction between the second air gaps 87b and an upper surface of the lower capping insulating layer 96 is less than a distance in the Z direction between the word lines 33 and the upper surface of the lower capping insulating layer 96). The second air gaps 87b may be disposed below the word lines 33 and the insulating patterns 37. In each of the second air gaps 87b, an upper portion of the second air gap 87b may be defined by the lower surface of the cell gate dielectric layer 30, both sides of the second air gap 87b located between the active patterns 9 adjacent to each other in the second horizontal direction (Y) may be defined by the active patterns 9, and both sides of the second air gap 87b not located between the active patterns 9 adjacent to each other in the second horizontal direction (Y) may be defined by the back gate dielectric layers 15, and first lower portions of the second air gap 87b vertically overlapping the bit line structures 81 and the bit line spacers 84 may be defined by the bit line structures 81 and the bit line spacers 84, and second lower portions of the second air gap 87b not vertically overlapping the bit line structures 81 and the bit line spacers 84 may be connected to the second air gap structure 90.

The second air gap 87b may be disposed between a structure including the first and second word lines 33 and the insulating pattern 37 and a structure including the bit line structures 81 and the bit line spacers 84, may be disposed between the second-first active pattern 9_2a and the third-first active pattern 9_3a, and may extend from a portion disposed between the second-first active pattern 9_2a and the third-first active pattern 9_3a to between the second-second active pattern 9_2b and the third-second active pattern 9_3b.

The second air gap structure 90 may also be referred to as third air gaps. The second air gap structure 90 may be disposed between the bit line structures 81 adjacent to each other and between the bit line spacers 84 adjacent to each other. In the second air gap structure 90, an upper portion of the second air gap structure 90 may be connected to the first air gap structure 87, both sides of the second air gap structure 90 may be defined by the bit line spacers 84, and a lower portion of the second air gap structure 90 may be defined by the lower capping insulating layer 96.

Each of the second air gaps 87b may have a first width in a first portion 87ba located between the active patterns 9 in the second horizontal direction (Y), and may have a second width, greater than the first width, in a second portion 87bb not located between the active patterns 9 in the second horizontal direction (Y) (see FIG. 5C). A width of each of the second air gaps 87b in the second horizontal direction (Y) may be greater than a width of each of the first air gaps 87a in the second horizontal direction (Y).

The memory region CR of the semiconductor device 1 may further include conductive patterns 42 and 48 and insulating structures 45 and 51 between the conductive patterns 42 and 48 (see FIGS. 6A and 6B).

The conductive patterns 42 and 48 may include lower conductive patterns 42 electrically connected to the second source/drain regions SD_U of the active patterns 9, and upper conductive patterns 48 electrically connected to the lower conductive patterns 42 on the lower conductive patterns 42. Each of the lower conductive patterns 42 may include a doped semiconductor layer. For example, the lower conductive patterns 42 may include polysilicon or polysilicon germanium having an N-type conductivity type.

According to an embodiment, the lower conductive patterns 42 may be extended source/drain regions. For example, the lower conductive patterns 42 may be formed of a doped semiconductor having a conductivity type, identical to a conductivity type of the second source/drain regions SD_U. For example, the lower conductive patterns 42 may include silicon having an N-type conductivity type or silicon-germanium having an N-type conductivity type. The lower conductive patterns 42 may include polysilicon or epitaxial silicon. The upper conductive patterns 48 may include at least one of a metal or a metal compound. For example, the upper conductive patterns 48 may include at least one of Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, and/or CoSi. The upper conductive patterns 48 may be landing pads.

Vertical center axes of the upper conductive patterns 48 and vertical center axes of the lower conductive patterns 42 may not be aligned. According to an embodiment, the vertical center axes of the upper conductive patterns 48 may be aligned with the vertical center axes of the lower conductive patterns 42.

The insulating structure 45 and 51 may include a first insulating structure 45 between side surfaces of the lower conductive patterns 42, and a second insulating structure 51 between side surfaces of the upper conductive patterns 48 (see FIG. 6A and 6B).

The memory region CR of the semiconductor device 1 may further include an information storage structure 60 (see FIGS. 6A and 6B).

The information storage structure 60 may be the information storage structure (DS of FIG. 2) described above. The information storage structure 60 may be a memory cell capacitor capable of storing information in a memory such as a DRAM or the like, but embodiments are not limited thereto. For example, the information storage structure 60 may be an information storage structure of MRAM or an information storage structure of FeRAM.

The information storage structure 60 may include first electrodes 53 connected to the upper conductive patterns 48 and extending in a vertical direction (Z), second electrodes 57 on side and upper surfaces of each of the first electrodes 53, and a dielectric layer 55 between the first electrodes 53 and the second electrode 57.

Each of the cell transistors (cTR in FIG. 2) described above may include the first source/drain region SD_L, the second source/drain region SD_U, the channel region CH, the word line 33, which may be a cell gate electrode, and the cell gate dielectric layer 30.

In an embodiment, the channel region CH may be a floating body, and the back gate electrode 21 facing the channel region CH may suppress or prevent performance of the cell transistor cTR from being deteriorated due to a floating body effect, and may improve a performance of the cell transistor cTR.

In an embodiment, the first air gaps 87a may reduce parasitic capacitance between the first source/drain regions SD_L of the active patterns 9 located on both sides of the back gate electrodes 21. For example, the first air gap 87a located between the first source/drain region SD_L of the first-first active pattern 9_1a and the first source/drain region SD_L of the second-first active pattern 9_2a may reduce parasitic capacitance between the first source/drain region SD_L of the first-first active pattern 9_1a and the first source/drain region SD_L of the second-first active pattern 9_2a, thereby suppressing or preventing the performance of the cell transistors cTR from being degraded and improving performance of the cell transistors cTR.

In an embodiment, the second air gaps 87b may reduce parasitic capacitance between the first source/drain regions SD_L of the active patterns 9 facing the word lines 33. For example, the second air gap 87b disposed between the first source/drain region SD_L of the second-first active pattern 9_2a and the first source/drain region SD_L of the third-first active pattern 9_3a may reduce parasitic capacitance between the first source/drain region SD_L of the second-first active pattern 9_2a and the first source/drain region SD_L of the third-first active pattern 9_3a, thereby suppressing or preventing the performance of the cell transistors cTR from being degraded and improving performance of the cell transistors cTR.

In an embodiment, as in FIG. 5C, portions of the second air gaps 87b disposed between the first source/drain regions SD_L of the active patterns 9, which are adjacent to each other, in the first horizontal direction (X) may reduce parasitic capacitance between the first source/drain regions SD_L of the active patterns 9, which are adjacent to each other, in the first horizontal direction (X).

In an embodiment, since the first air gap structure 87 including the first air gaps 87a and the second air gaps 87b may reduce parasitic capacitance between the first source/drain regions SD_L of the active patterns 9, which are adj acent to each other, in the second horizontal direction (Y) and parasitic capacitance between the first source/drain regions SD_L of the active patterns 9, which are adjacent to each other, in the first horizontal direction (X), the performance of the cell transistors cTR may be suppressed or prevented from being degraded and performance of the cell transistors cTR may be improved.

In an embodiment, the first air gaps 87a may reduce parasitic capacitance between the back gate electrodes 21 and the bit lines 75, and the second air gaps 87b may reduce parasitic capacitance between the word lines 33 and the bit lines 75. Therefore, the first air gap structure 87 including the first air gaps 87a and the second air gaps 87b may minimize a decrease in signal transmission speed in the back gate electrodes 21, the bit lines 75, and the word lines 33.

In an embodiment, the second air gap structures 90 may reduce parasitic capacitance between the bit lines 75. Therefore, the second air gap structures 90 may minimize a decrease in signal transmission speed of the bit lines 75.

Therefore, the air gap structure 93 including the first air gap structures 87 and the second air gap structures 90 may improve performance of the semiconductor device 1.

Hereinafter, various example embodiments of the memory region CR of the semiconductor device 1 will be described. Various example embodiments described below and embodiments described above may be combined with each other to form an example embodiment.

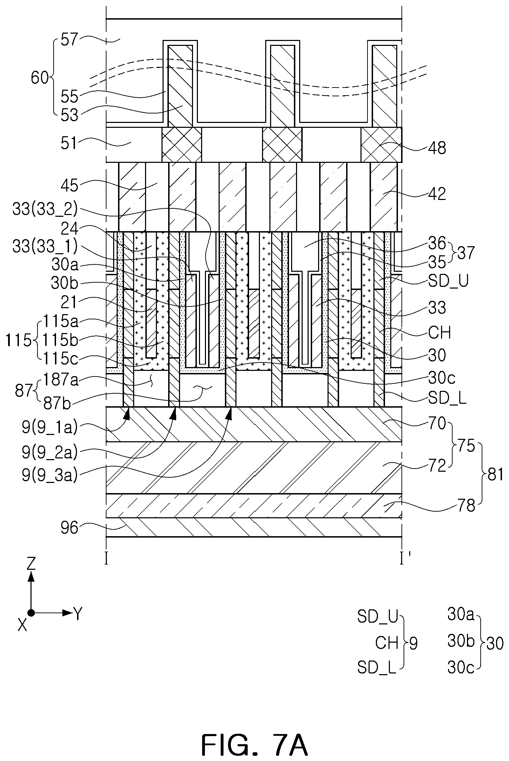

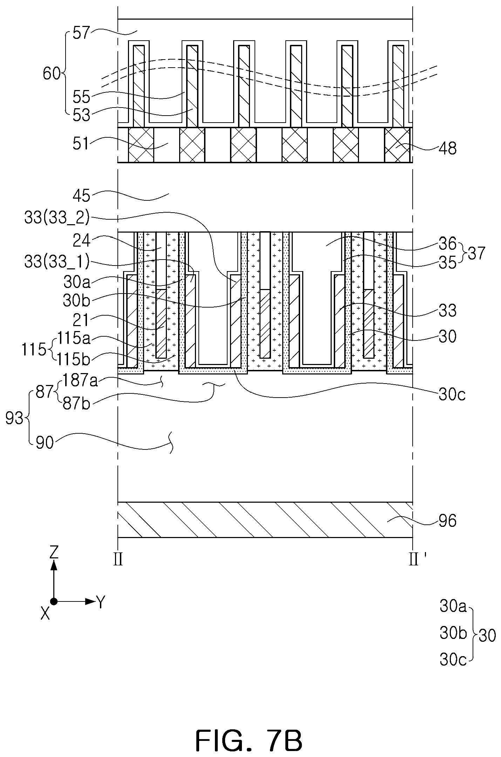

FIGS. 7A and 7B are cross-sectional views illustrating examples of semiconductor devices according to an embodiment. In FIGS. 7A and 7B, FIG. 7A is a cross-sectional view illustrating a region taken along line I-I' of FIG. 5A, and FIG. 7B is a cross-sectional view illustrating a region taken along line II-II' of FIG. 5A.

In an example embodiment, referring to FIGS. 7A and 7B, the back gate dielectric layer (15 of FIGS. 6A to 6C) described above may be replaced with a back gate dielectric layer 115 of FIGS. 7A and 7B, and the first air gap (87a of FIGS. 6A to 6C) described above may be replaced with a first air gap 187a of FIGS. 7A and 7B.

The back gate dielectric layer 115 may include first and second dielectric portions 115a and 115b contacting the active patterns 9, and a third dielectric portion 115c extending from the first and second dielectric portions 115a and 115b and covering or overlapping a lower surface of the back gate electrode 21. For example, in the back gate dielectric layer 115, the first dielectric portion 115a may be disposed between the first-first active pattern 9_1a and the back gate electrode 21 and between the first-first active pattern 9_1a and the back gate capping pattern 24, the second dielectric portion 115b may be disposed between the second-first active pattern 9_2a and the back gate electrode 21 and between the second-first active pattern 9_2a and the back gate capping pattern 24, and the third dielectric portion 115c may extend from the first and second dielectric portions 115a and 115b and may cover or overlap the lower surface of the back gate electrode 21.

In the first air gap 187a, an upper portion of the first air gap 187a may be defined by a lower surface of the back gate dielectric layer 115, both sides of the first air gap 187a located between the active patterns 9 adjacent to each other in the second horizontal direction (Y) may be defined by the active patterns 9 adjacent to each other in the second horizontal direction (Y), and the first air gap 187a not located between the active patterns 9 adjacent to each other in the second horizontal direction (Y) may be connected to the second air gap 87b, and first lower portions of the first air gap 187a vertically overlapping the bit line structures 81 and the bit line spacers 84 may be defined by the bit line structures 81 and the bit line spacers 84, and second lower portions of the first air gap 187a not vertically overlapping the bit line structures 81 and the bit line spacers 84 may be connected to the second air gap structure 90. The lower surface of the back gate dielectric layer 115 may be exposed by the first air gap 187a, and the active patterns 9 adjacent to each other in the second horizontal direction (Y) may be exposed by the first air gap 187a.

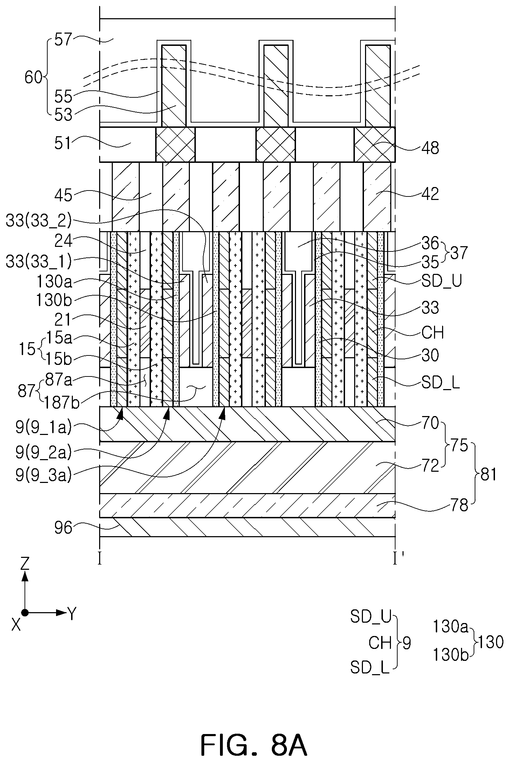

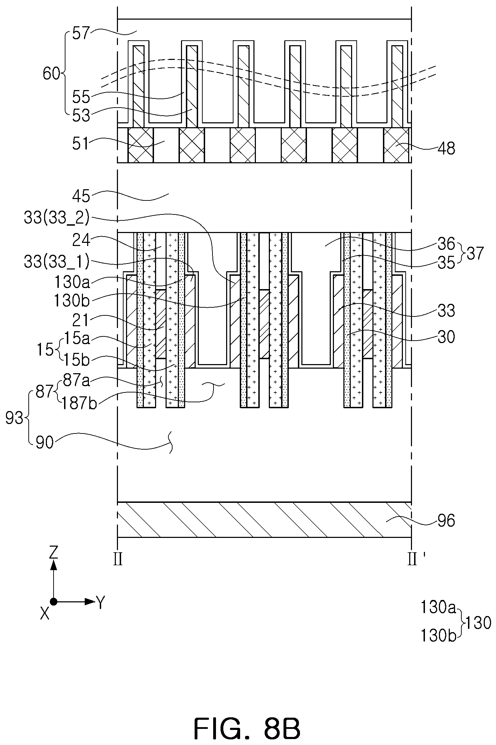

FIGS. 8A and 8B are cross-sectional views illustrating examples of semiconductor devices according to an embodiment. In FIGS. 8A and 8B, FIG. 8A is a cross-sectional view illustrating a region taken along line I-I' of FIG. 5A, and FIG. 8B is a cross-sectional view illustrating a region taken along line II-II' of FIG. 5A.

In an example embodiment, referring to FIGS. 8A and 8B, the cell gate dielectric layer (30 of FIGS. 6A to 6C) described above may be replaced with a cell gate dielectric layer 130 of FIGS. 8A and 8B, and the second air gap (87b of FIGS. 6A to 6C) described above may be replaced with a second air gap 187b of FIGS. 8A and 8B.

The cell gate dielectric layer 130 may extend from a portion disposed between the word line 33 and the active pattern 9 in an upward direction, to be disposed between the insulating pattern 37 and the active pattern 9, and may extend from a portion disposed between the word line 33 and the active pattern 9 in a downward direction (e.g., downward in the Z direction), to be disposed between the second air gap 187b and the active pattern 9. For example, between the second-first active pattern 9_2a and the third-first active pattern 9_3a, the cell gate dielectric layer 130 may include a first dielectric portion 130a and a second dielectric portion 130b, spaced apart from each other. For example, between the second-first active pattern 9_2a and the third-first active pattern 9_3a, the first dielectric portion 130a may extend from a portion disposed between the first word line 33_1 and the second-first active pattern 9_2a in an upward direction (e.g., upward in the Z direction), to be disposed between the insulating pattern 37 and the second-first active pattern 9_2a, and may extend from a portion disposed between the first word line 33_1 and the second-first active pattern 9_2a in a downward direction, to be disposed between the second air gap 187b and the second-first active pattern 9_2a, and the second dielectric portion 130b may extend from a portion disposed between the second word line 33_2 and the third-first active pattern 9_3a in an upward direction, to be disposed between the insulating pattern 37 and the third-first active pattern 9_3a, and may extend from a portion disposed between the second word line 33_2 and the third-first active pattern 9_3a in a downward direction, to be disposed between the second air gap 187b and the third-first active pattern 9_3a.

In the second air gap 187b, an upper portion of the second air gap 187b may be defined by lower surfaces of the word lines 33 and a lower surface of the insulating pattern 37, both sides of the second air gap 187b located between the active patterns 9 adjacent to each other in the second horizontal direction (Y) may be defined by the first dielectric portion 130a and the second dielectric portion 130b of the cell gate dielectric layer 130, both sides of the second air gap 187b not located between the active patterns 9 adjacent to each other in the second horizontal direction (Y) may be defined by the first dielectric portion 130a and the second dielectric portion 130b of the cell gate dielectric layer 130, first lower portions of the second air gap 187b vertically overlapping the bit line structures 81 and the bit line spacers 84 may be defined by the bit line structures 81 and the bit line spacers 84, and second lower portions of the second air gap 187b not vertically overlapping the bit line structures 81 and the bit line spacers 84 may be connected to the second air gap structure 90.

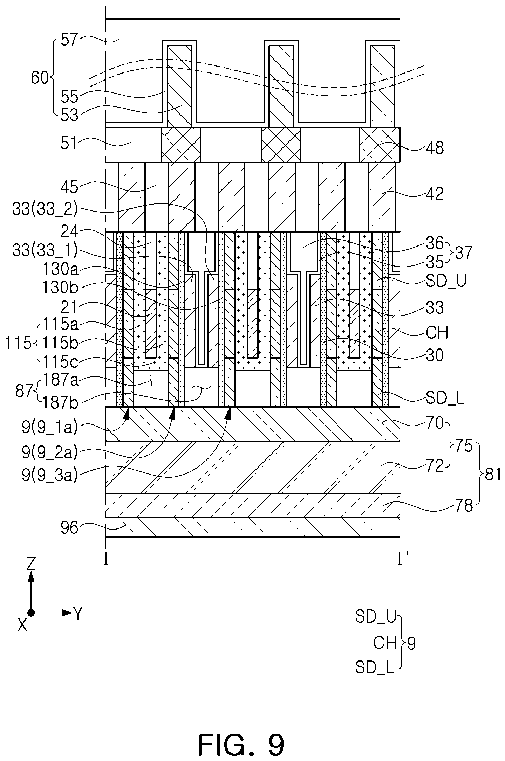

FIG. 9 is a cross-sectional view taken along line I-I' of FIG. 5A to illustrate an example of a semiconductor device according to an embodiment.

In an example embodiment, referring to FIG. 9, the back gate dielectric layer 15 in FIGS. 6A to 6C described above may be replaced with the back gate dielectric layer 115 including the first to third dielectric portions 115a, 115b, and 115c, as in FIGS. 7A and 7B, the first air gap 87a in FIGS. 6A to 6C described above may be replaced with the first air gap 187a in FIGS. 7A and 7B, the cell gate dielectric layer 30 in FIGS. 6A to 6C described above may be replaced with the cell gate dielectric layer 130 including the first and second dielectric portions 130a and 130b, as in FIGS. 8A and 8B, and the second air gap 87b in FIGS. 6A to 6C described above may be replaced with the second air gap 187b, as in FIGS. 8A and 8B.

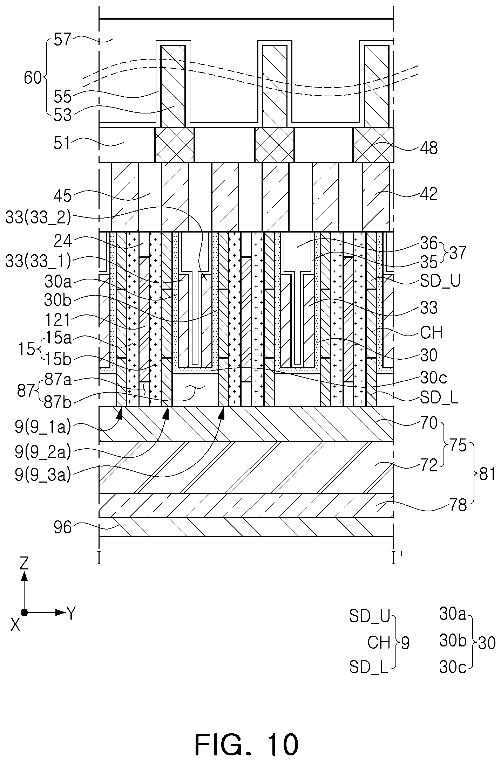

FIG. 10 is a cross-sectional view taken along line I-I' of FIG. 5A to illustrate an example of a semiconductor device according to an embodiment.

In an example embodiment, referring to FIG. 10, the back gate electrode 21 of any one of the embodiments of FIGS. 6A to 9 described above may be replaced with a back gate electrode 121 having an increased vertical length (e.g., length in the Z direction) as in FIG. 10.

The vertical length of the back gate electrode 121 may be greater than a vertical length of each of the word lines 33. A lower surface of the back gate electrode 121 may be disposed at a lower level than lower surfaces of the word lines 33 (e.g., a distance in the Z direction between the lower surface of the back gate electrode 121 and an upper surface of the lower capping insulating layer 96 is less than a distance in the Z direction between the lower surfaces of the word lines 33 and the upper surface of the lower capping insulating layer 96). An upper surface of the back gate electrode 121 may be disposed at a higher level than upper surfaces of the word lines 33 (e.g., a distance in the Z direction between the upper surface of the back gate electrode 121 and an upper surface of the lower capping insulating layer 96 is greater than a distance in the Z direction between the upper surfaces of the word lines 33 and the upper surface of the lower capping insulating layer 96).

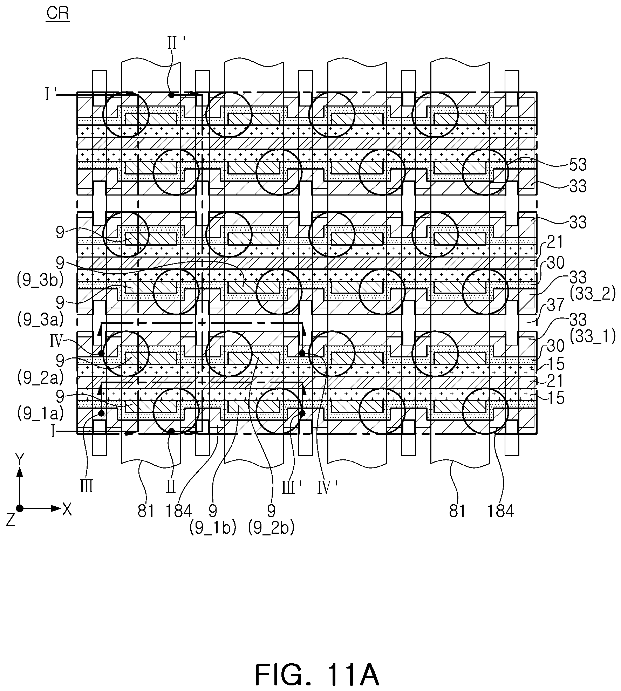

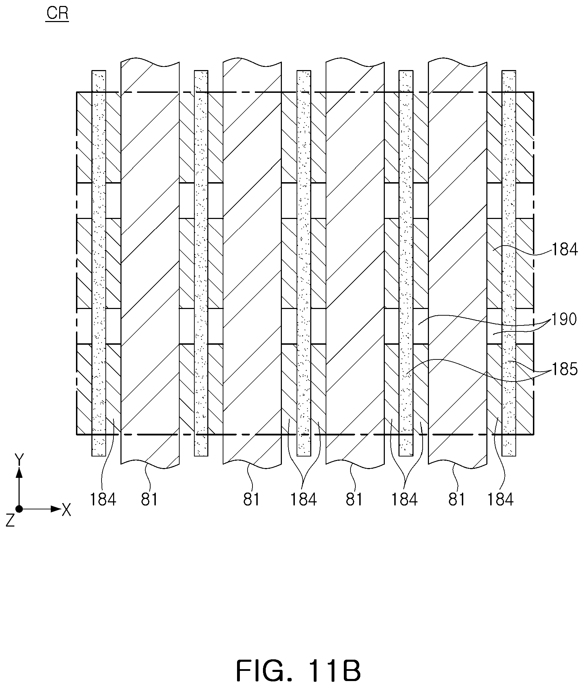

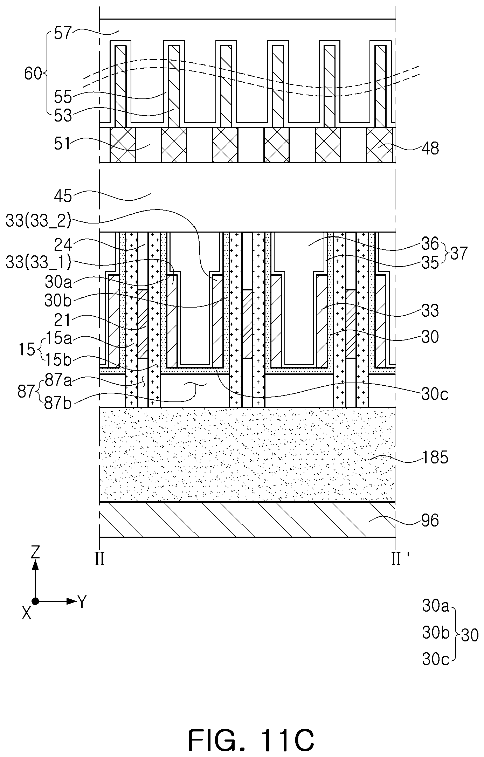

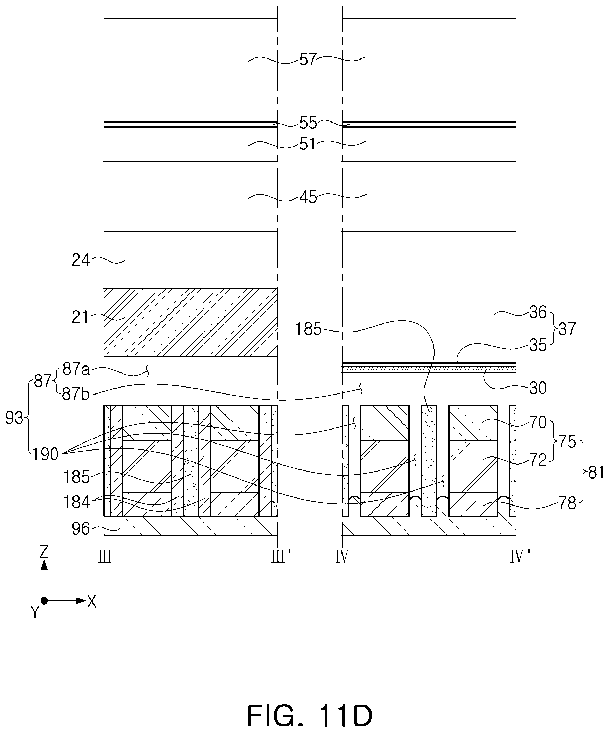

Referring to FIGS. 11A, 11B, 6A, 11C, and 11D, examples of semiconductor devices according to an embodiment will be described. In FIGS. 11A, 11B, 11C, and 11D, FIG. 11A is a plan view illustrating a modified example of some elements in the plan view of FIG. 5A above, FIG. 11B is a plan view illustrating some elements of FIG. 11A, FIG. 11C is a cross-sectional view illustrating a region taken along line II-II' of FIG. 11A, and FIG. 11D is a cross-sectional view illustrating regions taken along lines III-III' and IV-IV' of FIG. 11A. In FIG. 11A, a cross-sectional structure taken along line I-I' may be substantially the same as the cross-sectional structure indicated by I-I' of FIG. 6A. Therefore, FIG. 6A will be described with reference to FIGS. 11A to 11D.

In an example, referring to FIG. 6A and FIG. 11A to FIG. 11D, the bit line spacers (84 of FIG. 5A and FIG. 6C) described above may be replaced with bit line spacers 184 separated from each other in the second horizontal direction (Y).

The second air gap structures (90 of FIG. 6B and FIG. 6C) described above may be replaced with second air gap structures 190 disposed between the bit line spacers 184 separated from each other in the second horizontal direction (Y).

The memory region CR of the semiconductor device 1 may further include bit line shield structures 185 disposed between the bit line structures 81. The bit line shield structures 185 may be formed of a conductive material. Each of the bit line shield structures 185 may be disposed between the bit line structures 81 adjacent to each other, and between the bit line spacers 184.

Each of the second air gap structures 190 may be disposed between the bit line spacers 184 adjacent to each other in the second horizontal direction (Y), and between the bit line structure 81 and the bit line shield structure 185 adjacent to each other in the first horizontal direction (X). Upper portions of the second air gap structures 190 may be connected to the first air gap structures 87.

The lower capping insulating layer 96 may be in contact with lower surfaces of the bit line structures 81, lower surfaces of the bit line shield structures 185, and lower surfaces of the bit line spacers 184, and may define the lower portions of the second air gap structures 190.

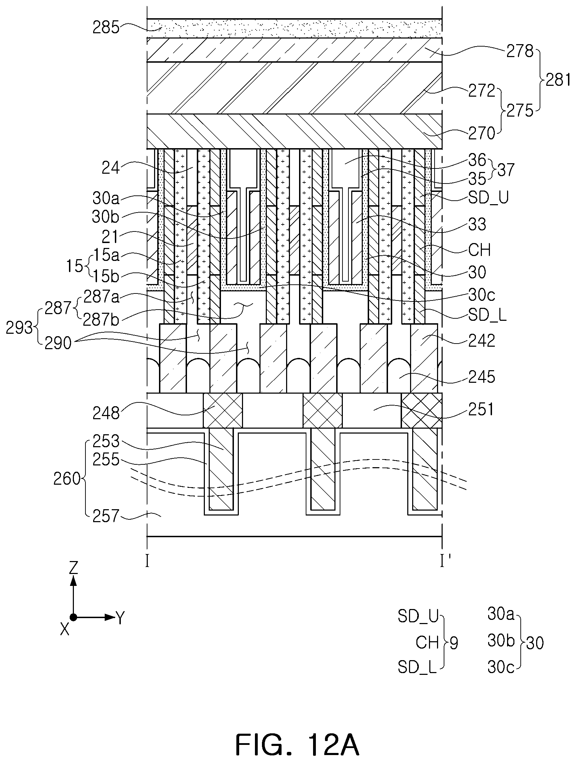

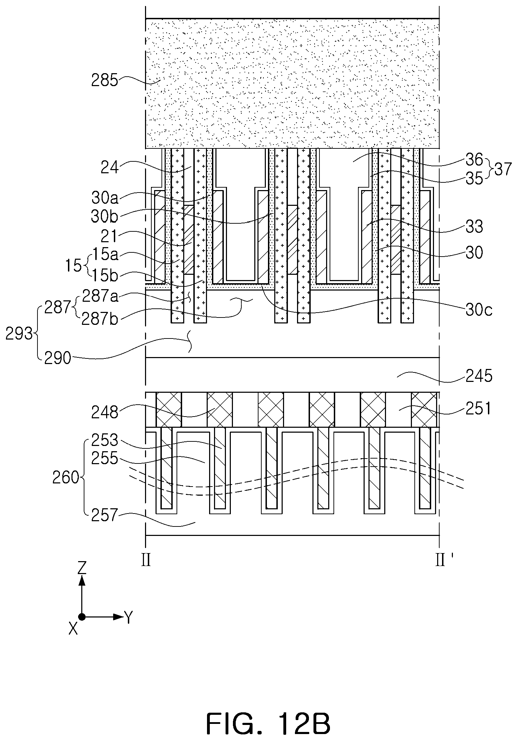

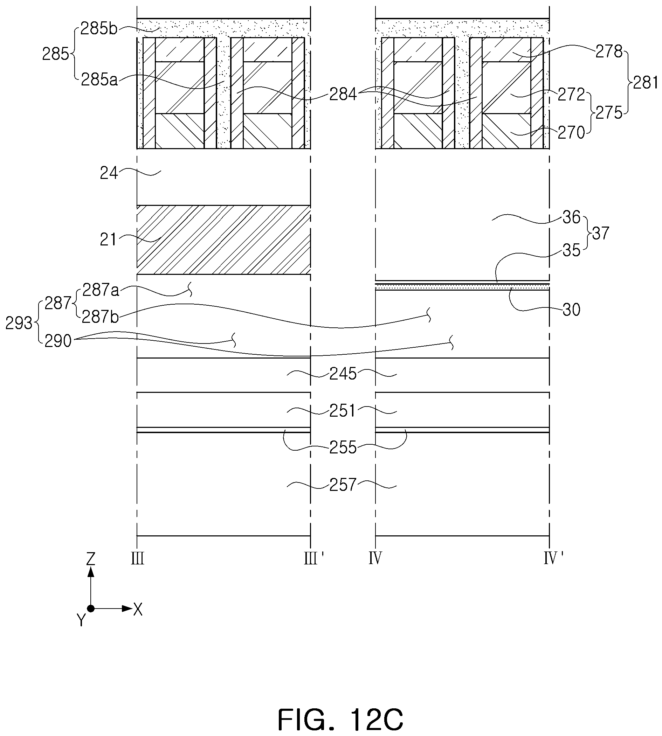

Referring to FIGS. 12A, 12B, and 12C, an example of a semiconductor device according to an embodiment will be described. In FIGS. 12A, 12B, and 12C, FIG. 12A is a cross-sectional view illustrating a region corresponding to a region taken along line I-I' of FIG. 5A, FIG. 12B is a cross-sectional view illustrating a region corresponding to a region taken along line II-II' of FIG. 5A, and FIG. 12C is a cross-sectional view illustrating regions corresponding to regions taken along lines III-III' and IV-IV' of FIG. 5A.

In an example, referring to FIGS. 12A to 12C, bit line structures 281 may be disposed on a structure including the active patterns 9, the word lines 33, the cell gate dielectric layer 30, the back gate dielectric layer 15, and the back gate capping pattern 24, described above. Each of the bit line structures 281 may include a bit line 275 and a bit line capping pattern 278 on the bit line 275. The bit line 275 may be the bit line (BL of FIG. 2) described above. The bit line 275 may be electrically connected to the second source/drain regions SD_U of the active patterns 9.

The bit line 275 may include doped polysilicon, a metal, a conductive metal nitride, a metal-semiconductor compound, a conductive metal oxide, conductive graphene, carbon nanotube, and/or a combination thereof. The bit line 275 may include a first material layer 270 and a second material layer 272 on the first material layer 270. The first material layer 270 may include a doped semiconductor material layer, and the second material layer 272 may include at least one of a metal, a metal compound, and/or a metal-semiconductor compound. The bit line capping pattern 278 may be formed of an insulating material, such as silicon nitride or the like.

Bit line spacers 284 may be disposed on side surfaces of the bit line structures 281. The bit line spacers 284 may be formed of an insulating material.

A bit line shield structure 285 including line portions 285a disposed between the bit line spacers 284 and a plate portion 285b extending from the line portions 285a and disposed on the bit line structures 281 and the bit line spacers 284 may be disposed between the bit line structures 281. The bit line shield structure 285 may be formed of a conductive material.

Conductive patterns 242 and 248 may be disposed below a structure including the active patterns 9, the word lines 33, the cell gate dielectric layer 30, the back gate dielectric layer 15, and the back gate capping pattern 24, described above.

The conductive patterns 242 and 248 may include first conductive patterns 242 electrically connected to the first source/drain regions SD_L of the active patterns 9, and second conductive patterns 248 disposed below the first conductive patterns 242.

A first air gap structure 287 disposed at substantially the same position and having the same structure as the first air gap structure (87 of FIGS. 6A to 6C) described above may be disposed. Therefore, the first air gap structure 287 may include first air gaps 287a and second air gaps 287b, respectively corresponding to the first air gaps (87a of FIGS. 6A to 6C) and the second air gaps (87b of FIGS. 6A to 6C) described above.

A first insulating pattern 245 may be disposed between side surfaces of lower regions of the first conductive patterns 242. An insulating pattern 251 may be disposed between side surfaces of the second conductive patterns 248.

A second air gap structure 290 may be disposed between side surfaces of the first conductive patterns 242. A lower portion of the second air gap structure 290 may be defined by the first insulating pattern 245, and an upper portion of the second air gap structure 290 may be connected to the first air gap structure 287. The second air gap structure 290 may reduce parasitic capacitance between the first conductive patterns 242.

The first and second air gap structures 287 and 290 may form an air gap structure 293.

An information storage structure 260 may be disposed below the second insulating pattern 251 and the second conductive patterns 248.

The information storage structure 260 may be the information storage structure (DS of FIG. 2) described above. The information storage structure 260 may include first electrodes 253 extending in the vertical direction (Z) and connected to the second conductive patterns 248, second electrodes 257 on the side and bottom surfaces of each of the first electrodes 253, and a dielectric layer 255 between the first electrodes 253 and the second electrode 257.

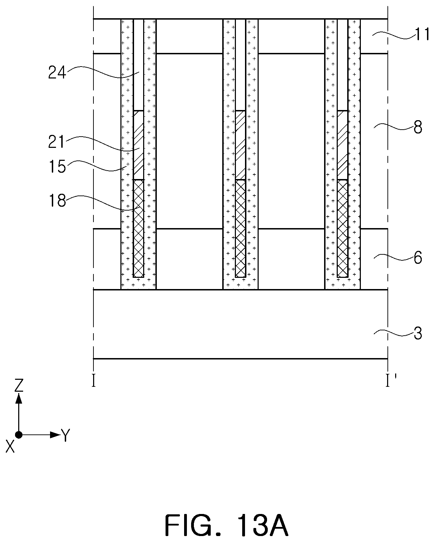

Next, with reference to FIGS. 13A, 13B, 14, 15, 16, 17A, 17B, 17C, 18A, and 18B, along with FIGS. 5A to 5C, an example of a method for forming a semiconductor device according to an embodiment will be described.

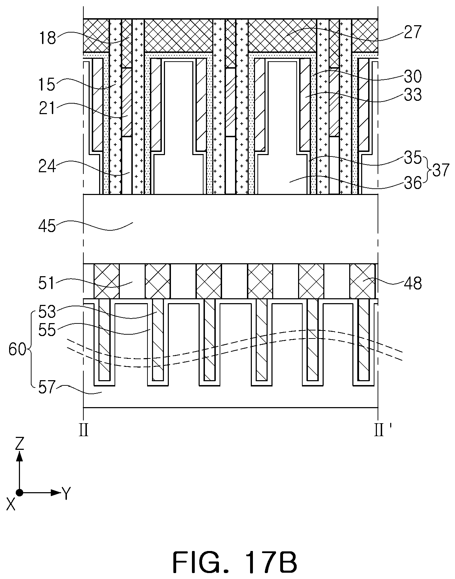

FIGS. 13A, 14, 15, 16, 17A, and 18A are cross-sectional views illustrating a region taken along line I-I' of FIG. 5A, FIG. 17B is a cross-sectional view illustrating a region taken along line II-II' of FIG. 5A, and FIGS. 13B, 17C, and 18B are cross-sectional views illustrating regions taken along lines III-III' and IV-IV' of FIG. 5A.

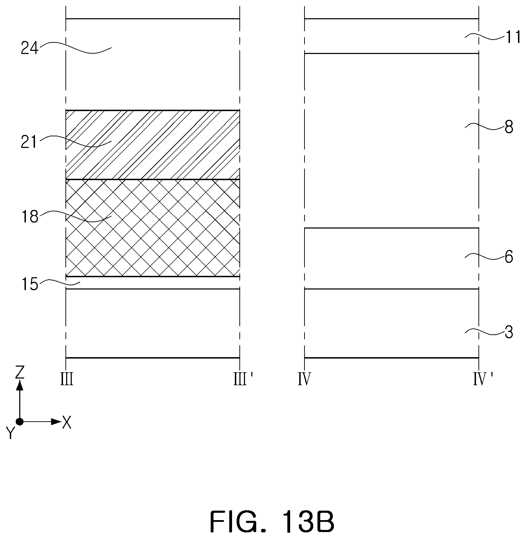

Referring to FIGS. 5A to 5C, FIGS. 13A and 13B, a base substrate 3, an insulating layer 6 on the base substrate 3, a semiconductor layer 8 on the insulating layer 6, and a mask layer 11 on the semiconductor layer 8 may be formed. The base substrate 3 may be a semiconductor substrate. The semiconductor layer 8 may be formed of a semiconductor material such as single crystal silicon or the like. Trenches penetrating or extending into the mask layer 11, the semiconductor layer 8, and the insulating layer 6 may be formed. In this case, the description will be based on a trench.

In an example, a back gate dielectric layer 15 conformally covering or overlapping an inner wall of the trench may be formed, a first sacrificial material layer 18 partially filling or in the trench may be formed on the back gate dielectric layer 15, a back gate electrode 21 may be formed on the first sacrificial material layer 18, and a back gate capping pattern 24 may be formed on the back gate electrode 21. An upper surface of the first sacrificial material layer 18 may be formed at a higher level than a lower surface of the semiconductor layer 8 (e.g., a distance in the Z direction between the upper surface of the first sacrificial material layer 18 and an upper surface of the base substrate 3 is greater than a distance in the Z direction between the lower surface of the semiconductor layer 8 and the upper surface of the base substrate 3), and an upper surface of the back gate electrode 21 may be formed at a lower level than an upper surface of the semiconductor layer 8 (e.g., a distance in the Z direction between the upper surface of the back gate electrode 21 and an upper surface of the base substrate 3 is less than a distance in the Z direction between the upper surface of the semiconductor layer 8 and the upper surface of the base substrate 3). The back gate electrode 21 may be formed of a conductive material, and the back gate capping pattern 24 may be formed of an insulating material.

In another example, the first sacrificial material layer 18 may be formed earlier than the back gate dielectric layer 15, and after the first sacrificial material layer 18 filling or in a lower region of the trench may be formed, the back gate dielectric layer 15 may be conformally formed, and then the back gate electrode 21 and the back gate capping pattern 24 may be formed.

The first sacrificial material layer 18 may be formed of a material that may be removed by a thermal decomposition process or an ashing process. For example, the first sacrificial material layer 18 may be formed of a carbon material or a polymer including carbon.

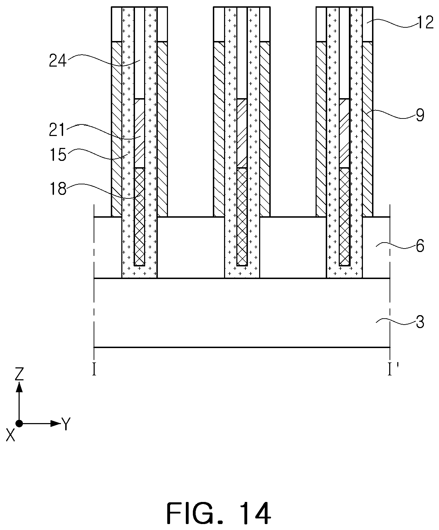

Referring to FIGS. 5A to 5C and FIG. 14, the mask layer 11 and the semiconductor layer 8 may be patterned to form active patterns 9 and mask patterns 12 that are sequentially stacked. Each of the active patterns 9 may be disposed in the first horizontal direction (X) and the second horizontal direction (Y), which are perpendicular to each other, as in FIGS. 5A to 5C.

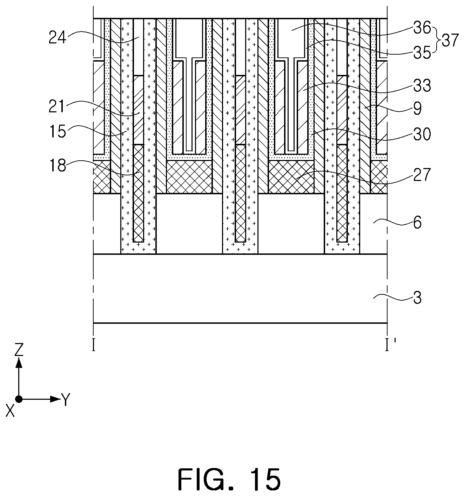

Referring to FIGS. 5A to 5C and FIG. 15, between adjacent back gate electrodes 21, a second sacrificial material layer 27 filling or in lower regions between adjacent active patterns 9 may be formed. Upper surface of the second sacrificial material layer 27 may be formed at a higher level than lower surfaces of the active patterns 9 (e.g., a distance in the Z direction between the upper surface of the second sacrificial material layer 27 and an upper surface of the base substrate 3 is greater than a distance in the Z direction between the lower surface of the active patterns 9 and the upper surface of the base substrate 3).

A cell gate dielectric layer 30 may be conformally formed on the second sacrificial material layer 27, word lines 33 spaced apart from each other may be formed on inner walls of the cell gate dielectric layer 30, and an insulating pattern 37 covering or overlapping the word lines 33 and the gate dielectric layer 30 may be formed. Upper surfaces of the word lines 33 may be formed at a lower level than upper surfaces of the active patterns 9 (e.g., a distance in the Z direction between the upper surfaces of the word lines 33 and an upper surface of the base substrate 3 is less than a distance in the Z direction between the upper surface of the active patterns 9 and the upper surface of the base substrate 3). Formation of the insulating pattern 37 may include conformally forming a first insulating layer 35 and forming a second insulating layer 36 on the first insulating layer 35.

After forming the second insulating layer 36, a planarization process may be performed until the upper surfaces of the active patterns 9 are exposed. The mask patterns (12 of FIG. 14) may be removed by the planarization process.

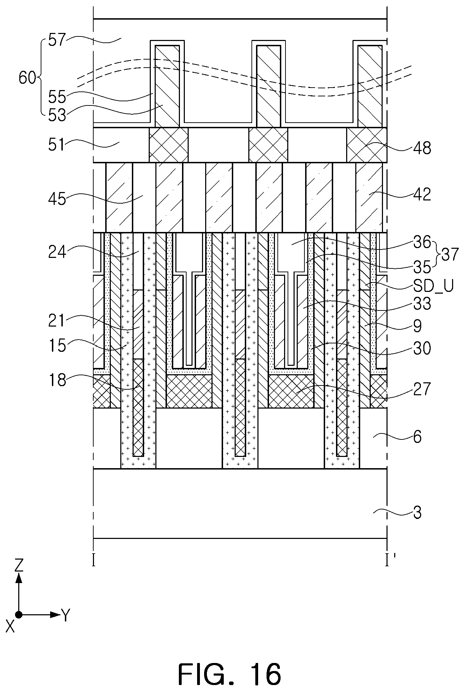

Referring to FIGS. 5A to 5C and FIG. 16, conductive patterns 42 and 48 connected to the active patterns 9, and insulating structures 45 and 51 between the conductive patterns 42 and 48 may be formed.

The conductive patterns 42 and 48 may include lower conductive patterns 42 connected to the active patterns 9, and upper conductive patterns 48 on the lower conductive patterns 42. The lower conductive patterns 42 may be formed of silicon having an N-type conductivity type. During formation of the lower conductive patterns 42, or before the formation of the lower conductive patterns 42, second source/drain regions SD_U may be formed in the upper regions of the active patterns 9. The second source/drain regions SD_U may have an N-type conductivity type. The insulating structures 45 and 51 may include a first insulating structure 45 between side surfaces of the lower conductive patterns 42, and a second insulating structure 51 between side surfaces of the upper conductive patterns 48.

An information storage structure 60 may be formed on the second insulating structure 51 and the upper conductive patterns 48. The information storage structure 60 may include first electrodes 53 connected to the upper conductive patterns 48 and extending in the vertical direction (Z), a second electrode 57 on side and upper surfaces of each of the first electrodes 53, and a dielectric layer 55 between the first electrodes 53 and the second electrode 57.

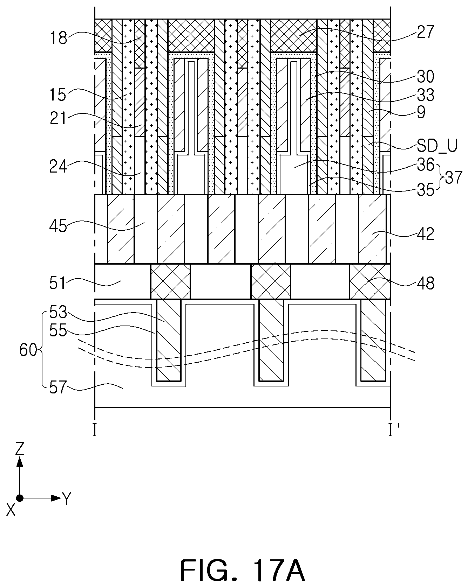

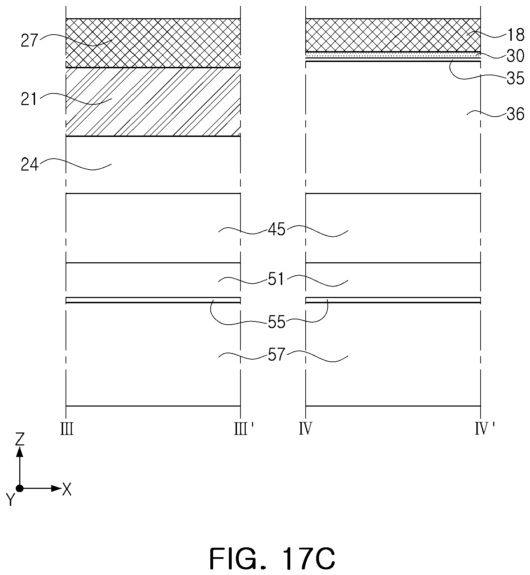

Referring to FIGS. 5A to 5C, FIGS. 17A, 17B, and 17C, the active patterns 9, the first sacrificial material layer 18, and the second sacrificial material layer 27 may be exposed while removing the base substrate (3 of FIG. 16) and the insulating layer (6 of FIG. 16). In this case, exposed surfaces of the active patterns 9, the first sacrificial material layer 18, and the second sacrificial material layer 27 may be located in an upper portion, as in FIGS. 17A, 17B, and 17C.

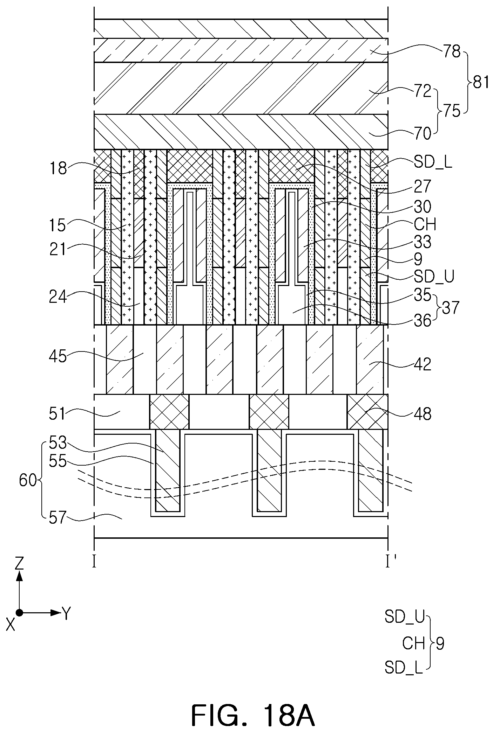

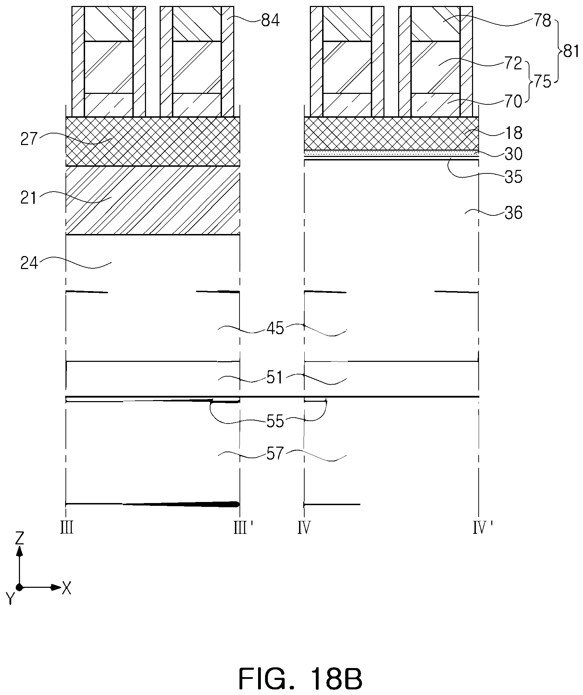

Referring to FIGS. 5A to 5C, FIGS. 18A, and 18B, bit line structures 81 may be formed on the exposed surfaces of the active patterns 9, the first sacrificial material layer 18, and the second sacrificial material layer 27.

Each of the bit line structures 81 may include a bit line 75 and a bit line capping pattern 78 on the bit line 75. The bit line 75 may be the bit line (BL of FIG. 2) described above. The bit line 75 may include a first material layer 70 and a second material layer 72 above the first material layer 70. The first material layer 70 may include a doped semiconductor material layer, and the second material layer 72 may include at least one of a metal, a metal compound, or a metal-semiconductor compound.

While forming the bit line structures 81, or before forming the bit line structures 81, first source/drain regions SD_L may be formed in regions of the active patterns 9. The first source/drain regions SD_L may have an N-type conductivity type. Within each of the active patterns 9, a channel region CH may be formed between the first source/drain region SD_L and the second source/drain region SD_U.

The bit line spacers 84 may be formed on side surfaces of the bit line structures 81. The first and second sacrificial material layers 18 and 27 may include portions vertically overlapping the bit line structures 81 and the bit line spacers 84, and portions exposed without vertically overlapping the bit line structures 81 and the bit line spacers 84.

Referring again to FIGS. 5A to 5C and FIGS. 6A to 6C, the first and second sacrificial material layers 18 and 27 may be removed.

In an example, removing the first and second sacrificial material layers 18 and 27 may include performing a thermal decomposition process to remove the first and second sacrificial material layers 18 and 27 by thermal decomposition through portions of the first and second sacrificial material layers 18 and 27 exposed and not vertically overlapping the bit line structures 81 and the bit line spacers 84.

In another example, removing the first and second sacrificial material layers 18 and 27 may include performing an ashing process to remove the first and second sacrificial material layers 18 and 27 by ashing through portions of the first and second sacrificial material layers 18 and 27 exposed and not vertically overlapping the bit line structures 81 and the bit line spacers 84.

A lower capping insulating layer 96 covering or overlapping lower surfaces of the bit line structures 81 and the bit line spacers 84 may be formed.

The first and second sacrificial material layers 18 and 27 may be removed to form a first air gap structure 87. Empty spaces from which the first sacrificial material layers 18 are removed may be formed as first air gaps 87a, and spaces from which the second sacrificial material layers 27 is removed may be formed as second air gaps 87b.

Between the bit line structures 81, empty spaces located between the bit line spacers 84, and of which lower surfaces are sealed by the lower capping insulating layer 96, as in FIG. 6B and FIG. 6C, may be formed as second air gap structures 90. The second air gap structures 90 may be connected to the first air gap structure 87. Therefore, an air gap structure 93 including the first and second air gap structures 87 and 90 may be formed.

According to embodiments, a cell transistor including source/drain regions spaced apart from each other in a vertical direction and a channel region between the source/drain regions may be provided. Air gaps may be disposed between source/drain regions formed in active patterns adjacent to each other in a horizontal direction. Since such air gaps may reduce parasitic capacitance that may occur between source/drain regions of adjacent cell transistors, it is possible to suppress or prevent performance degradation of the cell transistors and improve the performance of the cell transistors. Therefore, semiconductor devices including such cell transistors may have an increased degree of integration and improved performance.

Various advantages and effects of the present disclosure are not limited to the above-described contents, and will be more easily understood in the process of explaining specific embodiments.

While example embodiments have been illustrated and described above, it will be apparent to those skilled in the art that modifications and variations could be made without departing from the scope of the present disclosure as defined by the appended claims.

## Claims

1. active patterns (9) spaced apart from each other in a first direction (X) and a second direction (Y) that are perpendicular to each other, the active patterns (9) comprising a first-first active pattern (9-1a), a second-first active pattern (9-2a), and a third-first active pattern (9-3a), the second-first active pattern (9-2a) is between the first-first active pattern (9-1a) and the third-first active pattern (9-3a);
a back gate electrode (21) extending between the first-first active pattern (9-1a) and the second-first active pattern (9-2a) and extending in the first direction (X);
a first word line (33_1) and a second word line (33_2) extending between the second-first active pattern (9-2a) and the third-first active pattern (9-3a) and spaced apart from each other in the second direction (Y);
an insulating pattern (37) between the first word line (33_1) and the second word line (33_2);
a first air gap (87a) between the first-first active pattern (9-1a) and the second-first active pattern (9-2a),
**characterized in that**
the back gate electrode (21) is on the first air gap (87a); and
a second air gap (87b) is between the second-first active pattern (9-2a) and the third-first active pattern (9-3a), wherein the first word line (33_1), the second word line (33_2), and the insulating pattern (37) are on the second air gap (87b).

2. The semiconductor device of claim 1, wherein the active patterns (9) further comprise a first-second active pattern (9-1b), a second-second active pattern (9-2b), and a third-second active pattern (9-3b), the second-second active pattern (9-2b) is between the first-second active pattern (9-1b) and the third-second active pattern (9-3b),
the first-first active pattern (9-1a) and the first-second active pattern (9-1b) are spaced apart from each other in the first direction (X),
the second-first active pattern (9-2a) and the second-second active pattern (9-2b) are spaced apart from each other in the first direction (X),
the third-first active pattern (9-3a) and the third-second active pattern (9-3b) are spaced apart from each other in the first direction (X),
the first air gap (87a) is between the first-first active pattern (9-1a) and the second-first active pattern (9-2a) and is between the first-second active pattern (9-1b) and the second-second active pattern (9-2b), and
the second air gap (87b) is between the second-first active pattern (9-2a) and the third-first active pattern (9-3a) and is between the second-second active pattern (9-2b) and the third-second active pattern (9-3b).

3. The semiconductor device of claim 2, wherein a width of the second air gap (87b) in the second direction (Y) is greater than a width of the first air gap (87a) in the second direction (Y).

4. The semiconductor device of any one of claims 1 to 3, further comprising:
bit line structures (81) that are electrically connected to the active patterns (9) and extend parallel to each other in the second direction (Y); and
a third air gap (90) between the bit line structures (81),
wherein the third air gap (90) is connected to the first air gap (87a) and the second air gap (87b).

5. The semiconductor device of claim 4, wherein the bit line structures (81) include a first bit line structure extending in the second direction (Y) and electrically connected to a lower surface of the first-first active pattern (9-1a), a lower surface of the second-first active pattern (9-2a), and a lower surface of the third-first active pattern (9-3a).

6. The semiconductor device of claim 5, further comprising:
a bit line shield structure (185) between the bit line structures (81); and
bit line spacers (84),
wherein the bit line structures (81) further include a second bit line structure adjacent to the first bit line structure,
wherein the bit line spacers (84) and the third air gap (90) are between the bit line shield structure (185) and the first bit line structure and are between the bit line shield structure (185) and the second bit line structure.

7. The semiconductor device of claim 4 or 5, further comprising bit line spacers (84) on side surfaces of the bit line structures (81),
wherein the third air gap (90) is between a first pair of the bit line spacers (84) that are adjacent to each other in the first direction (X).

8. The semiconductor device of claim 7, wherein the bit line spacers (84) are spaced apart from each other in the second direction (Y), and
wherein the third air gap (90) is between a second pair of the bit line spacers (84) that are adjacent to each other in the second direction (Y).

9. The semiconductor device of any one of claims 5 to 8, wherein the first air gap (87a) is between the first bit line structure and the back gate electrode (21).

10. The semiconductor device of any one of claims 1 to 9, further comprising a back gate dielectric (15),
wherein the back gate dielectric (15) comprises:
a first back gate dielectric portion (15a) between the back gate electrode (21) and the first-first active pattern (9-1a) and extending between the first air gap (87a) and the first-first active pattern (9-1a); and
a second back gate dielectric portion (15b) between the back gate electrode (21) and the second-first active pattern (9-2a) and extending between the first air gap (87a) and the second-first active pattern (9-2a).

11. The semiconductor device of any one of claims 1 to 9, further comprising a back gate dielectric (15),
wherein the back gate dielectric (15) is between the back gate electrode (21) and the first-first active pattern (9-1a), between the back gate electrode (21) and the second-first active pattern (9-2a), and is on a lower surface of the back gate electrode (21), and
the first air gap (87a) is between a lower surface of the back gate dielectric (15) and an upper surface of the first bit line structure.

12. The semiconductor device of any one of claims 1 to 11, wherein the first word line (33_1), the second word line (33_2), and the insulating pattern (37) are on the second air gap (87b).

13. The semiconductor device of any one of claims 1 to 12, further comprising a cell gate dielectric layer (30),
wherein the cell gate dielectric layer (30) comprises:
a first cell gate dielectric portion (30a) that is between the first word line (33_1) and the second-first active pattern (9-2a) and is on a lower surface of the first word line (33_1); and
a second cell gate dielectric portion (30b) that is between the second word line (33_2) and the third-first active pattern (9-3a) and is on a lower surface of the second word line (33_2), and
a lower surface of the cell gate dielectric layer (30) is on the second air gap (87b).

14. The semiconductor device of any one of claims 1 to 12, further comprising a cell gate dielectric layer (30),
wherein the cell gate dielectric layer (30) comprises:
a first cell gate dielectric portion (30a) that is between the first word line (33_1) and the second-first active pattern (9-2a) and extends between the second-first active pattern (9-2a) and the second air gap (87b); and
a second cell gate dielectric portion (30b) that is between the second word line (33_2) and the third-first active pattern (9-3a) and extends between the third-first active pattern (9-3a) and the second air gap (87b).

15. The semiconductor device of any one of claims 1 to 14, wherein an upper end of the first air gap (87a) and an upper end of the second air gap (87b) are free from overlap in the second direction (Y).

## Patentansprüche

1. Halbleitervorrichtung, umfassend:
aktive Muster (9), die in einer ersten Richtung (X) und einer zweiten Richtung (Y), die senkrecht zueinander sind, voneinander beabstandet sind, wobei die aktiven Muster (9) ein erstes erstes aktives Muster (9-1a), ein zweites erstes aktives Muster (9-2a) und ein drittes erstes aktives Muster (9-3a) umfassen, wobei sich das zweite erste aktive Muster (9-2a) zwischen dem ersten ersten aktiven Muster (9-1a) und dem dritten ersten aktiven Muster (9-3a) befindet;
eine Back-Gate-Elektrode (21), die sich zwischen dem ersten ersten aktiven Muster (9-1a) und dem zweiten ersten aktiven Muster (9-2a) erstreckt und sich in der ersten Richtung (X) erstreckt;
eine erste Wortleitung (33_1) und eine zweite Wortleitung (33_2), die sich zwischen dem zweiten ersten aktiven Muster (9-2a) und dem dritten ersten aktiven Muster (9-3a) erstrecken und in der zweiten Richtung (Y) voneinander beabstandet sind;
ein Isoliermuster (37) zwischen der ersten Wortleitung (33_1) und der zweiten Wortleitung (33_2);
einen ersten Luftspalt (87a) zwischen dem ersten ersten aktiven Muster (9-1a) und dem zweiten ersten aktiven Muster (9-2a),
**dadurch gekennzeichnet, dass**
die Back-Gate-Elektrode (21) auf dem ersten Luftspalt (87a) angeordnet ist; und
sich ein zweiter Luftspalt (87b) zwischen dem zweiten ersten aktiven Muster (9-2a) und dem dritten ersten aktiven Muster (9-3a) befindet, wobei die erste Wortleitung (33_1), die zweite Wortleitung (33_2) und das Isoliermuster (37) auf dem zweiten Luftspalt (87b) angeordnet sind.

2. Halbleitervorrichtung nach Anspruch 1, wobei die aktiven Muster (9) ferner ein erstes zweites aktives Muster (9-1b), ein zweites zweites aktives Muster (9-2b) und ein drittes zweites aktives Muster (9-3b) umfassen, wobei sich das zweite zweite aktive Muster (9-2b) zwischen dem ersten zweiten aktiven Muster (9-1b) und dem dritten zweiten aktiven Muster (9-3b) befindet,
das erste erste aktive Muster (9-1a) und das erste zweite aktive Muster (9-1b) in der ersten Richtung (X) voneinander beabstandet sind,
das zweite erste aktive Muster (9-2a) und das zweite zweite aktive Muster (9-2b) in der ersten Richtung (X) voneinander beabstandet sind,
das dritte erste aktive Muster (9-3a) und das dritte zweite aktive Muster (9-3b) in der ersten Richtung (X) voneinander beabstandet sind,
der erste Luftspalt (87a) zwischen dem ersten ersten aktiven Muster (9-1a) und dem zweiten ersten aktiven Muster (9-2a) sowie zwischen dem ersten zweiten aktiven Muster (9-1b) und dem zweiten zweiten aktiven Muster (9-2b) angeordnet ist, und
der zweite Luftspalt (87b) zwischen dem zweiten ersten aktiven Muster (9-2a) und dem dritten ersten aktiven Muster (9-3a) sowie zwischen dem zweiten zweiten aktiven Muster (9-2b) und dem dritten zweiten aktiven Muster (9-3b) angeordnet ist.

3. Halbleitervorrichtung nach Anspruch 2, wobei eine Breite des zweiten Luftspalts (87b) in der zweiten Richtung (Y) größer als eine Breite des ersten Luftspalts (87a) in der zweiten Richtung (Y) ist.

4. Halbleitervorrichtung nach einem der Ansprüche 1 bis 3, ferner umfassend:
Bitleitungsstrukturen (81), die elektrisch mit den aktiven Mustern (9) verbunden sind und sich parallel zueinander in der zweiten Richtung (Y) erstrecken; und
einen dritten Luftspalt (90) zwischen den Bitleitungsstrukturen (81),
wobei der dritte Luftspalt (90) mit dem ersten Luftspalt (87a) und dem zweiten Luftspalt (87b) verbunden ist.

5. Halbleitervorrichtung nach Anspruch 4, wobei die Bitleitungsstrukturen (81) eine erste Bitleitungsstruktur umfassen, die sich in der zweiten Richtung (Y) erstreckt und elektrisch mit einer unteren Oberfläche des ersten ersten aktiven Musters (9-1a), einer unteren Oberfläche des zweiten ersten aktiven Musters (9-2a) und einer unteren Oberfläche des dritten ersten aktiven Musters (9-3a) verbunden ist.

6. Halbleitervorrichtung nach Anspruch 5, ferner umfassend:
eine Bitleitungsabschirmstruktur (185) zwischen den Bitleitungsstrukturen (81); und
Bitleitungsabstandshalter (84),
wobei die Bitleitungsstrukturen (81) ferner eine zweite Bitleitungsstruktur umfassen, die zu der ersten Bitleitungsstruktur benachbart ist,
wobei die Bitleitungsabstandshalter (84) und der dritte Luftspalt (90) zwischen der Bitleitungsabschirmstruktur (185) und der ersten Bitleitungsstruktur angeordnet sind und zwischen der Bitleitungsabschirmstruktur (185) und der zweiten Bitleitungsstruktur angeordnet sind.

7. Halbleitervorrichtung nach Anspruch 4 oder 5, ferner umfassend Bitleitungsabstandshalter (84) auf Seitenflächen der Bitleitungsstrukturen (81),
wobei der dritte Luftspalt (90) zwischen einem ersten Paar der Bitleitungsabstandshalter (84) angeordnet ist, die in der ersten Richtung (X) zueinander benachbart sind.

8. Halbleitervorrichtung nach Anspruch 7, wobei die Bitleitungsabstandshalter (84) in der zweiten Richtung (Y) voneinander beabstandet sind, und
wobei der dritte Luftspalt (90) zwischen einem zweiten Paar der Bitleitungsabstandshalter (84) angeordnet ist, die in der zweiten Richtung (Y) zueinander benachbart sind.

9. Halbleitervorrichtung nach einem der Ansprüche 5 bis 8, wobei der erste Luftspalt (87a) zwischen der ersten Bitleitungsstruktur und der Back-Gate-Elektrode (21) angeordnet ist.

10. Halbleitervorrichtung nach einem der Ansprüche 1 bis 9, ferner umfassend ein Back-Gate-Dielektrikum (15),
wobei das Back-Gate-Dielektrikum (15) umfasst:
einen ersten Back-Gate-Dielektrikumsabschnitt (15a) zwischen der Back-Gate-Elektrode (21) und dem ersten ersten aktiven Muster (9-1a), der sich zwischen dem ersten Luftspalt (87a) und dem ersten ersten aktiven Muster (9-1a) erstreckt; und
einen zweiten Back-Gate-Dielektrikumsabschnitt (15b) zwischen der Back-Gate-Elektrode (21) und dem zweiten ersten aktiven Muster (9-2a), der sich zwischen dem ersten Luftspalt (87a) und dem zweiten ersten aktiven Muster (9-2a) erstreckt.

11. Halbleitervorrichtung nach einem der Ansprüche 1 bis 9, ferner umfassend ein Back-Gate-Dielektrikum (15),
wobei das Back-Gate-Dielektrikum (15) zwischen der Back-Gate-Elektrode (21) und dem ersten ersten aktiven Muster (9-1a), zwischen der Back-Gate-Elektrode (21) und dem zweiten ersten aktiven Muster (9-2a) und auf einer unteren Oberfläche der Back-Gate-Elektrode (21) angeordnet ist, und
der erste Luftspalt (87a) zwischen einer unteren Oberfläche des Back-Gate-Dielektrikums (15) und einer oberen Oberfläche der ersten Bitleitungsstruktur angeordnet ist.

12. Halbleitervorrichtung nach einem der Ansprüche 1 bis 11, wobei die erste Wortleitung (33_1), die zweite Wortleitung (33_2) und das Isoliermuster (37) auf dem zweiten Luftspalt (87b) angeordnet sind.

13. Halbleitervorrichtung nach einem der Ansprüche 1 bis 12, ferner umfassend eine Zellgate-Dielektrikumschicht (30),
wobei die Zellgate-Dielektrikumschicht (30) umfasst:
einen ersten Zellgate-Dielektrikumsabschnitt (30a), der zwischen der ersten Wortleitung (33_1) und dem zweiten ersten aktiven Muster (9-2a) und auf einer unteren Oberfläche der ersten Wortleitung (33_1) angeordnet ist; und
einen zweiten Zellgate-Dielektrikumsabschnitt (30b), der zwischen der zweiten Wortleitung (33_2) und dem dritten ersten aktiven Muster (9-3a) und auf einer unteren Oberfläche der zweiten Wortleitung (33_2) angeordnet ist, und
eine untere Oberfläche der Zellgate-Dielektrikumschicht (30) auf dem zweiten Luftspalt (87b) angeordnet ist.

14. Halbleitervorrichtung nach einem der Ansprüche 1 bis 12, ferner umfassend eine Zellgate-Dielektrikumschicht (30),
wobei die Zellgate-Dielektrikumschicht (30) umfasst:
einen ersten Zellgate-Dielektrikumsabschnitt (30a), der zwischen der ersten Wortleitung (33_1) und dem zweiten ersten aktiven Muster (9-2a) angeordnet ist und sich zwischen dem zweiten ersten aktiven Muster (9-2a) und dem zweiten Luftspalt (87b) erstreckt; und
einen zweiten Zellgate-Dielektrikumsabschnitt (30b), der zwischen der zweiten Wortleitung (33_2) und dem dritten ersten aktiven Muster (9-3a) angeordnet ist und sich zwischen dem dritten ersten aktiven Muster (9-3a) und dem zweiten Luftspalt (87b) erstreckt.

15. Halbleitervorrichtung nach einem der Ansprüche 1 bis 14, wobei ein oberes Ende des ersten Luftspalts (87a) und ein oberes Ende des zweiten Luftspalts (87b) einander in der zweiten Richtung (Y) nicht überlappen.

## Revendications

1. Dispositif à semi-conducteur comprenant :
des motifs actifs (9) espacés les uns des autres dans une première direction (X) et une deuxième direction (Y) qui sont perpendiculaires l'une à l'autre, les motifs actifs (9) comprenant un premier-premier motif actif (9-1a), un deuxième-premier motif actif (9-2a) et un troisième-premier motif actif (9-3a), le deuxième-premier motif actif (9-2a) étant entre le premier-premier motif actif (9-1a) et le troisième-premier motif actif (9-3a) ;
une électrode de grille arrière (21) s'étendant entre le premier-premier motif actif (9-1a) et le deuxième-premier motif actif (9-2a) et s'étendant dans la première direction (X) ;
une première ligne de mots (33_1) et une deuxième ligne de mots (33_2) s'étendant entre le deuxième-premier motif actif (9-2a) et le troisième-premier motif actif (9-3a) et espacées l'une de l'autre dans la deuxième direction (Y) ;
un motif isolant (37) entre la première ligne de mots (33_1) et la deuxième ligne de mots (33_2) ;
un premier espace d'air (87a) entre le premier-premier motif actif (9-1a) et le deuxième-premier motif actif (9-2a),
**caractérisé en ce que**
l'électrode de grille arrière (21) est sur le premier espace d'air (87a) ; et
un deuxième espace d'air (87b) est entre le deuxième-premier motif actif (9-2a) et le troisième-premier motif actif (9-3a), dans lequel la première ligne de mots (33_1), la deuxième ligne de mots (33_2) et le motif isolant (37) sont sur le deuxième espace d'air (87b).

2. Dispositif à semi-conducteur selon la revendication 1, dans lequel les motifs actifs (9) comprennent en outre un premier-deuxième motif actif (9-1b), un deuxième-deuxième motif actif (9-2b) et un troisième-deuxième motif actif (9-3b), le deuxième-deuxième motif actif (9-2b) étant entre le premier-deuxième motif actif (9-1b) et le troisième-deuxième motif actif (9-3b),
le premier-premier motif actif (9-1a) et le premier-deuxième motif actif (9-1b) sont espacés l'un de l'autre dans la première direction (X),
le deuxième-premier motif actif (9-2a) et le deuxième-deuxième motif actif (9-2b) sont espacés l'un de l'autre dans la première direction (X),
le troisième-premier motif actif (9-3a) et le troisième-deuxième motif actif (9-3b) sont espacés l'un de l'autre dans la première direction (X),
le premier espace d'air (87a) est entre le premier-premier motif actif (9-1a) et le deuxième-premier motif actif (9-2a) et est entre le premier-deuxième motif actif (9-1b) et le deuxième-deuxième motif actif (9-2b), et
le deuxième espace d'air (87b) est entre le deuxième-premier motif actif (9-2a) et le troisième-premier motif actif (9-3a) et est entre le deuxième-deuxième motif actif (9-2b) et le troisième-deuxième motif actif (9-3b).

3. Dispositif à semi-conducteur selon la revendication 2, dans lequel une largeur du deuxième espace d'air (87b) dans la deuxième direction (Y) est supérieure à une largeur du premier espace d'air (87a) dans la deuxième direction (Y).

4. Dispositif à semi-conducteur selon l'une quelconque des revendications 1 à 3, comprenant en outre :
des structures de ligne de bits (81) qui sont connectées électriquement aux motifs actifs (9) et s'étendent parallèlement les unes aux autres dans la deuxième direction (Y) ; et
un troisième espace d'air (90) entre les structures de ligne de bits (81),
dans lequel le troisième espace d'air (90) est relié au premier espace d'air (87a) et au deuxième espace d'air (87b).

5. Dispositif à semi-conducteur selon la revendication 4, dans lequel les structures de ligne de bits (81) comprennent une première structure de ligne de bits s'étendant dans la deuxième direction (Y) et connectée électriquement à une surface inférieure du premier-premier motif actif (9-1a), à une surface inférieure du deuxième-premier motif actif (9-2a) et à une surface inférieure du troisième-premier motif actif (9-3a).

6. Dispositif à semi-conducteur selon la revendication 5, comprenant en outre :
une structure de blindage de ligne de bits (185) entre les structures de ligne de bits (81) ; et
des espaceurs de ligne de bits (84),
dans lequel les structures de ligne de bits (81) comprennent en outre une deuxième structure de ligne de bits adjacente à la première structure de ligne de bits,
dans lequel les espaceurs de ligne de bits (84) et le troisième espace d'air (90) sont entre la structure de blindage de ligne de bits (185) et la première structure de ligne de bits et sont entre la structure de blindage de ligne de bits (185) et la deuxième structure de ligne de bits.

7. Dispositif à semi-conducteur selon la revendication 4 ou 5, comprenant en outre des espaceurs de ligne de bits (84) sur des surfaces latérales des structures de ligne de bits (81),
dans lequel le troisième espace d'air (90) est entre une première paire des espaceurs de ligne de bits (84) qui sont adjacents les uns aux autres dans la première direction (X).

8. Dispositif à semi-conducteur selon la revendication 7, dans lequel les espaceurs de ligne de bits (84) sont espacés les uns des autres dans la deuxième direction (Y), et
dans lequel le troisième espace d'air (90) est entre une deuxième paire des espaceurs de ligne de bits (84) qui sont adjacents les uns aux autres dans la deuxième direction (Y).

9. Dispositif à semi-conducteur selon l'une quelconque des revendications 5 à 8, dans lequel le premier espace d'air (87a) est entre la première structure de ligne de bits et l'électrode de grille arrière (21).

10. Dispositif à semi-conducteur selon l'une quelconque des revendications 1 à 9, comprenant en outre un diélectrique de grille arrière (15),
dans lequel le diélectrique de grille arrière (15) comprend :
une première partie de diélectrique de grille arrière (15a) entre l'électrode de grille arrière (21) et le premier-premier motif actif (9-1a) et s'étendant entre le premier espace d'air (87a) et le premier-premier motif actif (9-1a) ; et
une deuxième partie de diélectrique de grille arrière (15b) entre l'électrode de grille arrière (21) et le deuxième-premier motif actif (9-2a) et s'étendant entre le premier espace d'air (87a) et le deuxième-premier motif actif (9-2a).

11. Dispositif à semi-conducteur selon l'une quelconque des revendications 1 à 9, comprenant en outre un diélectrique de grille arrière (15),
dans lequel le diélectrique de grille arrière (15) est entre l'électrode de grille arrière (21) et le premier-premier motif actif (9-1a), entre l'électrode de grille arrière (21) et le deuxième-premier motif actif (9-2a), et est sur une surface inférieure de l'électrode de grille arrière (21), et
le premier espace d'air (87a) est entre une surface inférieure du diélectrique de grille arrière (15) et une surface supérieure de la première structure de ligne de bits.

12. Dispositif à semi-conducteur selon l'une quelconque des revendications 1 à 11, dans lequel la première ligne de mots (33_1), la deuxième ligne de mots (33_2) et le motif isolant (37) sont sur le deuxième espace d'air (87b).

13. Dispositif à semi-conducteur selon l'une quelconque des revendications 1 à 12, comprenant en outre une couche diélectrique de grille de cellule (30),
dans lequel la couche diélectrique de grille de cellule (30) comprend :
une première partie de diélectrique de grille de cellule (30a) qui est entre la première ligne de mots (33_1) et le deuxième-premier motif actif (9-2a) et est sur une surface inférieure de la première ligne de mots (33_1) ; et
une deuxième partie de diélectrique de grille de cellule (30b) qui est entre la deuxième ligne de mots (33_2) et le troisième-premier motif actif (9-3a) et est sur une surface inférieure de la deuxième ligne de mots (33_2), et
une surface inférieure de la couche diélectrique de grille de cellule (30) est sur le deuxième espace d'air (87b).

14. Dispositif à semi-conducteur selon l'une quelconque des revendications 1 à 12, comprenant en outre une couche diélectrique de grille de cellule (30),
dans lequel la couche diélectrique de grille de cellule (30) comprend :
une première partie de diélectrique de grille de cellule (30a) qui est entre la première ligne de mots (33_1) et le deuxième-premier motif actif (9-2a) et s'étend entre le deuxième-premier motif actif (9-2a) et le deuxième espace d'air (87b) ; et
une deuxième partie de diélectrique de grille de cellule (30b) qui est entre la deuxième ligne de mots (33_2) et le troisième-premier motif actif (9-3a) et s'étend entre le troisième-premier motif actif (9-3a) et le deuxième espace d'air (87b).

15. Dispositif à semi-conducteur selon l'une quelconque des revendications 1 à 14, dans lequel une extrémité supérieure du premier espace d'air (87a) et une extrémité supérieure du deuxième espace d'air (87b) ne se chevauchent pas dans la deuxième direction (Y).
